# EUROPEAN PATENT APPLICATION

(11) **EP 4 246 557 A1**
(43) Date of publication of application: **20.09.2023**
(21) Application number: 21891718.5
(22) Date of filing: 02.11.2021
(51) Int. Cl.: H01L 21/3205, H01L 21/768, H01L 23/522, H01L 27/146, H04N 5/374, H04N 5/3745

(54) **IMAGING ELEMENT AND IMAGING DEVICE**

(30) Priority: 12.11.2020 JP 2020189019
(71) Applicant: Sony Semiconductor Solutions Corporation, Atsugi-shi, Kanagawa 243-0014 (JP)
(72) Inventor: MACHIDA, Takashi, Atsugi-shi, Kanagawa 243-0014 (JP)
(74) Representative: MFG Patentanwälte Meyer-Wildhagen Meggle-Freund Gerhard PartG mbB
(86) International application number: PCT/JP2021/040390
(87) International publication number: WO 2022/102471

(57) **Abstract**

An imaging element according to an aspect of the present disclosure includes: a floating diffusion layer (FD) that holds a charge; photoelectric conversion elements (PD) being four or more and sharing the floating diffusion layer (FD); and a plurality of transfer gates (TG) that is provided for each of the photoelectric conversion elements (PD) being four or more and sharing the floating diffusion layer (FD) and that is configured to output the charge from the photoelectric conversion elements (PD) being four or more and sharing the floating diffusion layer (FD), in which the photoelectric conversion elements (PD) being four or more and sharing the floating diffusion layer (FD) are arranged in a matrix together with the floating diffusion layer (FD), and the transfer gate (TG) of each of the photoelectric conversion elements (PD) being two or more and not sharing the floating diffusion layer (FD) is integrated with each other.

## Description

### Field

The present disclosure relates to an imaging element and an imaging device.

### Background

In order to obtain downsized imaging elements and high-density pixels, there has been a development of an imaging element having a three-dimensional structure in which a part of pixel components (for example, an amplification transistor) is formed on another silicon substrate to form a stacked structure (refer to Patent Literature 1, for example).

A first layer incorporating a photodiode (PD) includes a transfer gate (TG), a floating diffusion (FD), and a substrate contact, in addition to the PD. Usually, a signal line for applying bias to these parts is drawn to the upper side of the second layer by a through-substrate contact, and is formed in the second layer together with a signal line for an element placed in the second layer. At this time, the through-substrate contact forming portion cannot be used as an effective region of the second layer, making it necessary to reduce the number of through-substrate contacts in order to achieve cell miniaturization and characteristic improvement.

In order to reduce the number of through-substrate contacts, Patent Literature 1 proposes a technique of reducing the number of through-substrate contacts in a pixel array by extending polysilicon forming a transfer gate to the outside of the pixel array and raising the polysilicon to a second layer outside the pixel array.

### Citation List

### Patent Literature

Patent Literature 1: WO 2019/131965 A

### Summary

### Technical Problem

However, for achieving cell miniaturization, one FD is usually shared by a plurality of PDs. In this case, it is necessary to make TG independent between pixels sharing the same FD. In this state, in an attempt to extend the material (for example, polysilicon) for forming TG to the outer periphery of the pixel array, one layer of polysilicon is not enough to perform layout of TG. In this case, two or more layers of polysilicon are required, increasing the number of manufacturing steps. In addition, forming two layers of polysilicon increases the interlayer distance between the first and second silicon layers, making it necessary to increase the depth of the through-substrate contact, causing the reduction of yield.

In view of these, the present disclosure provides an imaging element and an imaging device capable of reducing the number of through-substrate contacts and improving productivity.

### Solution to Problem

An imaging element according to an aspect of the present disclosure includes: a floating diffusion layer that holds a charge; photoelectric conversion elements being four or more and sharing the floating diffusion layer; and a plurality of transfer gates that is provided for each of the photoelectric conversion elements being four or more and sharing the floating diffusion layer and that is configured to output the charge from the photoelectric conversion elements being four or more and sharing the floating diffusion layer, in which the photoelectric conversion elements being four or more and sharing the floating diffusion layer are arranged in a matrix together with the floating diffusion layer, and the transfer gate of each of the photoelectric conversion elements being two or more and not sharing the floating diffusion layer is integrated with each other.

### Brief Description of Drawings

FIG. 1 is a diagram depicting an example of a schematic configuration of an imaging element according to a first embodiment.
FIG. 2 is a diagram depicting an example of a pixel circuit according to the first embodiment.
FIG. 3 is a diagram depicting an example of a connection mode of the pixel circuit according to the first embodiment.
FIG. 4 is a view depicting an example of a planar layout of a first layer according to the first embodiment.
FIG. 5 is a diagram depicting an example of a longitudinal cross-sectional configuration of the imaging element according to the first embodiment.
FIG. 6 is a diagram depicting a first modification of the pixel circuit according to the first embodiment.
FIG. 7 is a diagram depicting a second modification of the pixel circuit according to the first embodiment.
FIG. 8 is a diagram depicting a third modification of the pixel circuit according to the first embodiment.
FIG. 9 is a diagram depicting a first modification of the longitudinal cross-sectional configuration of the imaging element according to the first embodiment.
FIG. 10 is a diagram depicting a second modification of the longitudinal cross-sectional configuration of the imaging element according to the first embodiment.
FIG. 11 is a diagram depicting a first modification of a planar layout of a first layer according to the first embodiment.
FIG. 12 is a diagram depicting a second modification of the planar layout of the first layer according to the first embodiment.
FIG. 13 is a diagram depicting a third modification of the planar layout of the first layer according to the first embodiment.
FIG. 14 is a diagram depicting an example of a longitudinal cross-sectional configuration of an imaging element according to the third modification of FIG. 13.
FIG. 15 is a diagram depicting an example of a connection mode of the pixel circuit according to a second embodiment.
FIG. 16 is a view depicting an example of a planar layout of a first layer according to the second embodiment.
FIG. 17 is a diagram depicting an example of a connection mode of a pixel circuit according to a third embodiment.
FIG. 18 is a view depicting an example of a planar layout of a first layer according to the third embodiment.
FIG. 19 is a diagram depicting an example of a connection mode of the pixel circuit according to a fourth embodiment.
FIG. 20 is a view depicting an example of a planar layout of a first layer according to the fourth embodiment.
FIG. 21 is a view depicting a modification of the planar layout of the first layer according to the fourth embodiment.
FIG. 22 is a diagram depicting an example of a schematic configuration of an imaging device.
FIG. 23 is a block diagram depicting an example of schematic configuration of a vehicle control system.
FIG. 24 is a diagram of assistance in explaining an example of installation positions of an outside-vehicle information detecting section and an imaging section.

### Description of Embodiments

Embodiments of the present disclosure will be described below in detail with reference to the drawings. Note that the element, the device, the system, the method, and the like according to the present disclosure are not limited by this embodiment. Moreover, in each of the following embodiments, the same parts are denoted by the same reference symbols, and a repetitive description thereof will be omitted.

One or more embodiments (including examples and modifications) described below can each be implemented independently. On the other hand, at least some of the plurality of embodiments described below may be appropriately combined with at least some of other embodiments. The plurality of embodiments may include novel features different from each other. Accordingly, the plurality of embodiments can contribute to achieving or solving different objects or problems, and can exhibit different effects. The effects described in individual embodiments are merely examples, and thus, there may be other effects, not limited to the exemplified effects.

The present disclosure will be described in the following order.
1. First embodiment
   1-1. Example of schematic configuration of imaging element
   1-2. Example of pixel circuit
   1-3. Example of connection mode of pixel circuit
   1-4. Example of planar layout of first layer
   1-5. Example of cross-sectional configuration of imaging element
   1-6. Modification of pixel circuit
   1-7. Modification of cross-sectional configuration of imaging element
   1-8. Modification of planar layout of first layer
   1-9. Action and effect
2. Second embodiment
3. Third embodiment
4. Fourth embodiment
5. Other embodiments
6. Application example
7. Examples of application to products
8. Supplementary notes

### <1. First embodiment>

### <1-1. Example of schematic configuration of imaging element>

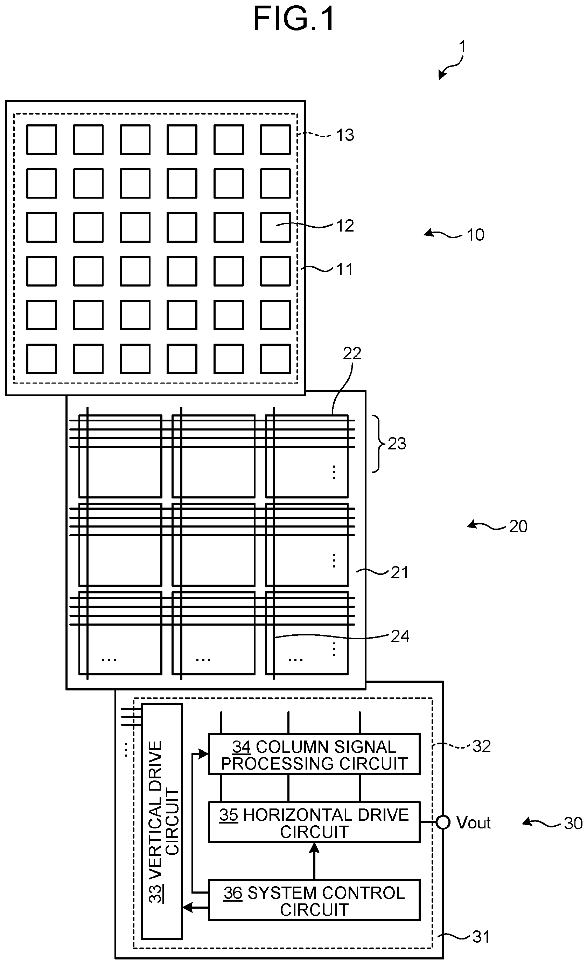

An example of a schematic configuration of an imaging element 1 according to a first embodiment will be described with reference to FIG. 1. FIG. 1 is a diagram depicting an example of a schematic configuration of the imaging element 1 according to the first embodiment.

As depicted in FIG. 1, the imaging element 1 includes three substrates, namely, a first substrate 10, a second substrate 20, and a third substrate 30. The structure of the imaging element 1 is a three-dimensional structure in which the three substrates, namely, the first substrate 10, the second substrate 20, and the third substrate 30, are bonded with each other. The first substrate 10, the second substrate 20, and the third substrate 30 are stacked in this order. The first substrate 10 is the first layer, the second substrate 20 is the second layer, and the third substrate 30 is the third layer.

The first substrate 10 includes a semiconductor substrate 11 and a plurality of sensor pixels 12 that performs photoelectric conversion. The semiconductor substrate 11 includes each of the sensor pixels 12. These sensor pixels 12 are provided in a matrix (two-dimensional array) in a pixel region 13 of the first substrate 10.

The second substrate 20 includes a semiconductor substrate 21, a readout circuit 22 that outputs a pixel signal, a plurality of pixel drive lines 23 extending in a row direction, and a plurality of vertical signal lines 24 extending in a column direction. The semiconductor substrate 21 has one readout circuit 22 for every four sensor pixels 12. The readout circuit 22 outputs a pixel signal based on the charge output from the sensor pixel 12.

The third substrate 30 includes a semiconductor substrate 31 and a logic circuit 32 that processes a pixel signal. The semiconductor substrate 31 includes a logic circuit 32. The logic circuit 32 includes, for example, a vertical drive circuit 33, a column signal processing circuit 34, a horizontal drive circuit 35, and a system control circuit 36.

The logic circuit 32 outputs an output voltage Vout for each sensor pixel 12 to the outside. In the logic circuit 32, for example, a low resistance region formed of silicide using a self aligned silicide process such as CoSi₂ or NiSi may be formed on the surface of an impurity diffusion region in contact with the source electrode and the drain electrode.

For example, the vertical drive circuit 33 sequentially selects the plurality of sensor pixels 12 row by row.

The column signal processing circuit 34 performs, for example, correlated double sampling (CDS) processing on the pixel signal output from each sensor pixel 12 of the row selected by the vertical drive circuit 33. For example, the column signal processing circuit 34 extracts the signal level of each pixel signal by executing the CDS processing, and holds pixel data corresponding to the amount of light received by each sensor pixel 12.

For example, the horizontal drive circuit 35 sequentially outputs the pixel data held in the column signal processing circuit 34 to the outside.

The system control circuit 36 controls drive of each block (Vertical drive circuit 33, column signal processing circuit 34, and horizontal drive circuit 35) in the logic circuit 32, for example.

### <2. Example of pixel circuit>

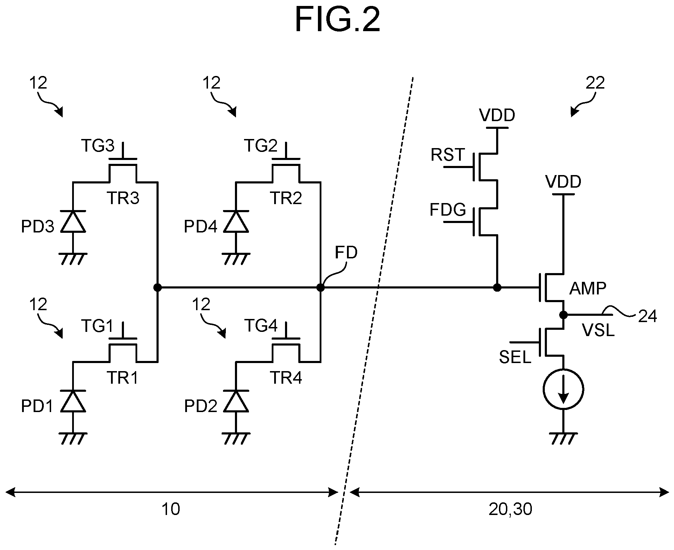

Next, an example of a pixel circuit according to the first embodiment will be described with reference to FIG. 2. FIG. 2 is a diagram depicting an example of a pixel circuit according to the first embodiment.

As depicted in FIG. 2, four sensor pixels 12 share one readout circuit 22. Here, "share" indicates that the four sensor pixels 12 are electrically connected to the common readout circuit 22, that is, the outputs of the four sensor pixels 12 are input to the common readout circuit 22.

Each sensor pixel 12 has a common component. In FIG. 2, in order to distinguish the components of each sensor pixel 12 from each other, an identification number (1, 2, 3, 4) is added to the end of the code of the component of each sensor pixel 12. Hereinafter, when it is necessary to distinguish the components of each sensor pixel 12 from each other, an identification number is assigned to the end of the reference sign of the component of each sensor pixel 12, but when it is not necessary to distinguish the components of each sensor pixel 12 from each other, the identification number at the end of the reference sign of the component of each sensor pixel 12 is omitted.

Each sensor pixel 12 includes: a photodiode PD; and a transfer transistor TR electrically connected to the photodiode PD, for example. These sensor pixels 12 share the floating diffusion FD electrically connected to each transfer transistor TR. Here, "share" means that the photodiodes PD of each of the sensor pixels 12 are electrically connected to the floating diffusion FD. The photodiode PD, the transfer transistor TR, the floating diffusion FD, and the like are provided on the first substrate 10, for example.

The photodiode PD performs photoelectric conversion to generate a charge corresponding to the amount of received light. The photodiode PD has a cathode electrically connected to the source of the transfer transistor TR and has an anode electrically connected to a reference potential line (for example, ground). The photodiode PD is an example of a photoelectric conversion element.

The drain of the transfer transistor TR is electrically connected to the floating diffusion FD. The transfer gate TG, which is a gate of the transfer transistor TR, is electrically connected to the pixel drive line 23 (refer to FIG. 1). The transfer transistor TR is, for example, a complementary metal oxide semiconductor (CMOS) transistor.

The floating diffusion FD is used commonly by the sensor pixels 12 sharing one readout circuit 22, and is electrically connected to an input end of the commonly used readout circuit 22 in the sensor pixels 12. The floating diffusion FD temporarily holds the charge output from the photodiode PD via the transfer transistor TR. The floating diffusion FD is an example of a floating diffusion layer.

The readout circuit 22 includes a reset transistor RST, a selection transistor SEL, an amplification transistor AMP, and a FD transfer transistor FDG, for example. The reset transistor RST, the selection transistor SEL, the amplification transistor AMP, the FD transfer transistor FDG, and the like are provided on the second substrate 20 or the third substrate 30, for example. The reset transistor RST, the amplification transistor AMP, the selection transistor SEL, and the FD transfer transistor FDG are CMOS transistors, for example. The selection transistor SEL and the FD transfer transistor FDG may be omitted as necessary.

The source of the FD transfer transistor FDG (input end of the readout circuit 22) is electrically connected to the floating diffusion FD, and the drain of the FD transfer transistor FDG is electrically connected to the source of the reset transistor RST. The gate of the FD transfer transistor FDG is electrically connected to the pixel drive line 23 (refer to FIG. 1).

The drain of the reset transistor RST is electrically connected to a power supply line VDD. The gate of the reset transistor RST is electrically connected to the pixel drive line 23 (refer to FIG. 1).

The source of the amplification transistor AMP is electrically connected to the drain of the selection transistor SEL, and the drain of the amplification transistor AMP is electrically connected to the power supply line VDD. The gate of the amplification transistor AMP is electrically connected to the source of the FD transfer transistor FDG.

The drain of the selection transistor SEL (an output end of the readout circuit 22) is electrically connected to the vertical signal line 24 (VSL in FIG. 2), while the gate of the selection transistor SEL is electrically connected to the pixel drive line 23 (refer to FIG. 1).

When the transfer transistor TR is turned on, the transfer transistor TR transfers the charge of the photodiode PD to the floating diffusion FD.

The reset transistor RST resets the potential of the floating diffusion FD to a predetermined potential. When the reset transistor RST is turned on, the potential of the floating diffusion FD is reset to the potential of the power supply line VDD. The selection transistor SEL controls an output timing of the pixel signal from the readout circuit 22.

The amplification transistor AMP generates a signal at a voltage corresponding to the level of the charge held in the floating diffusion FD as a pixel signal. The amplification transistor AMP constitutes a source follower type amplifier, and outputs a pixel signal having a voltage corresponding to the level of the charge generated in the photodiode PD.

When the selection transistor SEL is turned on, the amplification transistor AMP amplifies the potential of the floating diffusion FD, and outputs a voltage corresponding to the potential to the column signal processing circuit 34 (refer to FIG. 1) via the vertical signal line 24.

The FD transfer transistor FDG is used when switching the conversion efficiency. In general, a pixel signal is weak at the time of shooting in a dark place. Based on Q = CV, when the capacitance (FD capacitance C) of the floating diffusion FD is large at the time of performing charge-voltage conversion, this results in a small V at the time of conversion into a voltage by the amplification transistor AMP. In contrast, the pixel signal has a great strength in a bright place, making it difficult to hold the charge of the photodiode PD at the floating diffusion FD unless the FD capacitance C is large enough. Furthermore, the FD capacitance C needs to be large so that V when converted into a voltage by the amplification transistor AMP does not become too high (in other words, so as to be low).

That is, turning on the FD transfer transistor FDG increases the gate capacitance corresponding to the FD transfer transistor FDG, leading to an increase in the entire FD capacitance C. In contrast, turning off the FD transfer transistor FDG decreases the entire FD capacitance C. In this manner, switching on/off of the FD transfer transistor FDG can achieve variable FD capacitance C, making it possible to switch the conversion efficiency.

### <1-3. Example of connection mode of pixel circuit>

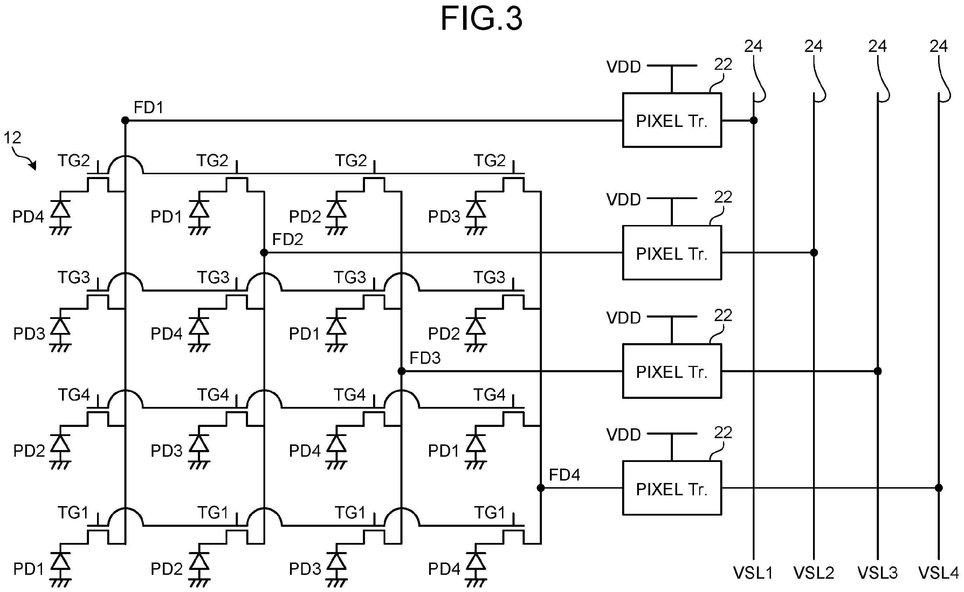

An example of a connection mode of the pixel circuit according to the first embodiment will be described with reference to FIG. 3. FIG. 3 is a diagram depicting an example of a connection mode of the pixel circuit according to the first embodiment.

As depicted in FIG. 3, the plurality of readout circuits 22 is arranged, for example, side by side in the extending direction of the vertical signal line 24 (for example, the column direction). These readout circuits 22 are allocated to the individual vertical signal lines 24 one to one. In the example of FIG. 3, four readout circuits 22 and four floating diffusions FD (FD1 to FD4) are provided. Furthermore, in the example of FIG. 3, four vertical signal lines 24 are provided, each with an identification number (1, 2, 3, or 4) added to the end of the VSL in order to distinguish the vertical signal line 24 (the similar applies to the other drawings) from each other.

Four sensor pixels 12, namely, four photodiodes PD (PD1 to PD4) and four transfer transistors TR (TR1 to TR4), are arranged for each readout circuit 22, that is, each floating diffusion FD (FD1 to FD4). The four photodiodes PD (PD1 to PD4) sharing the floating diffusion FD are electrically connected to each other. In addition, transfer gates TG (TG1 to TG4) of the four transfer transistors TR not sharing the floating diffusion FD are electrically connected to each other. Here, "share" means that the photodiode PD is electrically connected to the floating diffusion FD.

Hereinafter, the "a photodiode PD connected to a floating diffusion FD via a transfer transistor TR" is simply referred to as "PD of FD". In the example of FIG. 3, the transfer gates TG1 in each of the PD1 of the FD1, the PD2 of the FD2, the PD3 of the FD3, and the PD4 of the FD4 are electrically connected to each other. The transfer gates TG4 in each of the PD2 of the FD1, the PD3 of the FD2, the PD4 of the FD3, and the PD1 of the FD4 are electrically connected to each other. The transfer gates TG3 in each of the PD3 of the FD1, the PD4 of the FD2, the PD1 of the FD3, and the PD2 of the FD4 are electrically connected to each other. The transfer gates TG4 in each of the PD4 of the FD1, the PD1 of the FD2, the PD2 of the FD3, and the PD3 of the FD4 are electrically connected to each other.

### <1-4. Example of planar layout of first layer>

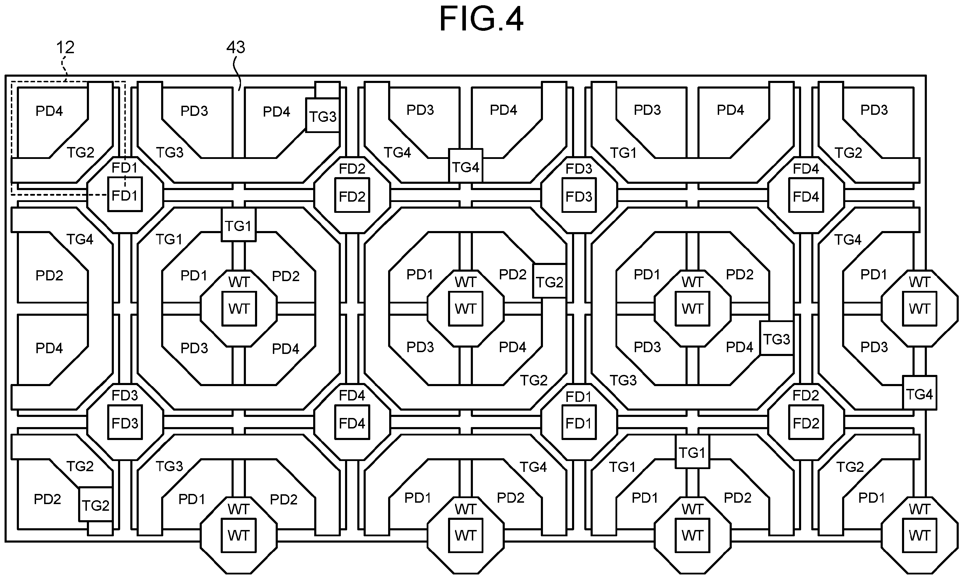

An example of a planar layout of a first layer according to the first embodiment will be described with reference to FIG. 4. FIG. 4 is a diagram depicting an example of a planar layout of the first layer according to the first embodiment. In the example of FIG. 4, squares surrounding the reference signs FD (FD1 to FD4), TG (TG1 to TG4), or WT indicate positions of the through-substrate contacts (TCS) (similar applies to the other drawings).

As depicted in FIG. 4, four adjacent photodiodes PD sharing one floating diffusion FD are arranged in a matrix together with the floating diffusion FD. The floating diffusion FD is provided at an interval of 2 rows and 2 columns of the sensor pixels 12.

Well taps WT, positioned at equal intervals from four floating diffusions FD adjacent to each other, are arranged in a matrix. In the example of FIG. 4, the well tap WT is provided at a central position of a square formed by four floating diffusions FD adjacent to each other. Specifically, the well tap WT is provided at a position diagonal to the floating diffusion FD in the sensor pixel 12.

In the four photodiodes PD not sharing the floating diffusion FD, the transfer gates TG are integrated and electrically connected to each other. When the four floating diffusions FD are formed as one set including two in the vertical direction and two in the horizontal direction, the transfer gates TG (TG1 to TG4), formed with polysilicon or tungsten, for example, are integrated as one region corresponding to this set. That is, the transfer gates TG (TG1 to TG4) are formed in a region surrounded by the four floating diffusions FD. In the example of FIG. 4, the integrated transfer gates TG (TG1 to TG4) are formed in a ring shape (annular shape). One through-substrate contact is electrically connected to the transfer gate TG. Therefore, the through-substrate contact is connected to the transfer gate TG at one point. In this manner, the annular transfer gate TG is shared by the four photodiodes PD, making it possible to reduce the number of through-substrate contacts.

Here, the adjacent photodiodes PD, that is, at least a part (or all) between the adjacent sensor pixels 12 is separated by a lattice-shaped insulator (an element isolating portion 43 having an insulating property to be described below), with the annular transfer gate TG being disposed to run over the lattice-shaped insulator.

### <1-5. Example of cross-sectional configuration of imaging element>

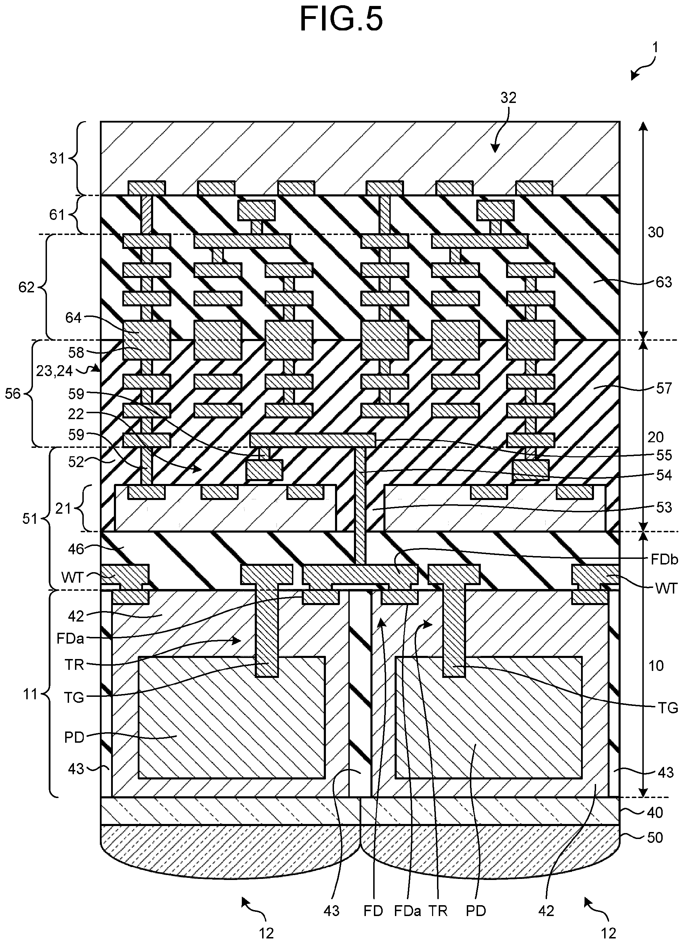

An example of a cross-sectional configuration of the imaging element 1 according to the first embodiment will be described with reference to FIG. 5. FIG. 5 is a diagram depicting an example of a longitudinal cross-sectional configuration (cross-sectional configuration in the vertical direction) of the imaging element 1 according to the first embodiment.

As depicted in FIG. 5, the imaging element 1 has a configuration in which a first substrate 10, a second substrate 20, and a third substrate 30 are stacked in this order, and further includes a color filter 40 and a light receiving lens 50 on the back surface side (light incident surface side) of the first substrate 10. For example, one color filter 40 and one light receiving lens 50 are provided for each sensor pixel 12. That is, the imaging element 1 is a back-illuminated device.

The first substrate 10 has a configuration in which an insulating layer 46 is stacked on a semiconductor substrate 11. The first substrate 10 includes the insulating layer 46 as a part of an interlayer insulating film 51. The insulating layer 46 is provided in a gap between the semiconductor substrate 11 and a semiconductor substrate 21 described below.

The semiconductor substrate 11 is formed with a silicon substrate. The semiconductor substrate 11 includes a p-well layer 42 at a part of the surface and in their vicinity, for example, and includes a photodiode PD of a conductivity type different from that of the p-well layer 42 in another region (region deeper than the p-well layer 42). The p-well layer 42 is formed with a p-type semiconductor region. The photodiode PD is formed with a semiconductor region of a conductivity type (specifically, n-type) different from that of the p-well layer 42. The semiconductor substrate 11 includes, within the p-well layer 42, a floating diffusion FD as a semiconductor region of a conductivity type (specifically, n-type) different from that of the p-well layer 42.

In the example of FIG. 5, one floating diffusion FD includes four adjacent diffusion layers (floating diffusion layers) FDa and one connection layer FDb. The diffusion layer FDa is provided in each photodiode PD, and the individual diffusion layers FDa of the four adjacent photodiodes PD are electrically connected to each other by one connection layer FDb. The connection layer FDb, provided in the insulating layer 46, is positioned above each diffusion layer FDa so as to be in contact with each diffusion layer FDa. The connection layer FDb is formed of the same material (for example, polysilicon) as the transfer gate TG.

The first substrate 10 includes a photodiode PD and a transfer transistor TR for each sensor pixel 12, and in addition, the floating diffusion FD and the well tap WT are shared by the four sensor pixels 12 (refer to FIG. 4). The transfer transistor TR, the floating diffusion FD, and the well tap WT are provided on the semiconductor substrate 11 in a portion on the front surface side (side opposite to light incident surface side, that is, the second substrate 20 side). The well tap WT is electrically connected to the p-well layer 42 (for example, a well contact formed in the p-well layer 42).

The first substrate 10 includes an element isolating portion 43 that separates each sensor pixel 12. The element isolating portion 43 is formed so as to extend in a normal direction of the semiconductor substrate 11 (a direction perpendicular to the surface of the semiconductor substrate 11). The element isolating portion 43 is provided between two sensor pixels 12 adjacent to each other. The element isolating portion 43 electrically isolates the sensor pixels 12 adjacent to each other, from each other. The element isolating portion 43 is formed of silicon oxide, for example. The element isolating portion 43 penetrates the semiconductor substrate 11 (full trench), for example, so as to electrically completely isolate two or more adjacent sensor pixels 12 from each other.

The color filter 40 is provided on the back surface side of the semiconductor substrate 11. The color filter 40 is provided, for example, at a position in contact with the back surface of the semiconductor substrate 11 and facing the sensor pixel 12. The light receiving lens 50 is, for example, in contact with the back surface of the color filter 40 and is provided at a position facing the sensor pixel 12 via the color filter 40.

The second substrate 20 has a configuration in which an insulating layer 52 is stacked on the semiconductor substrate 21. The second substrate 20 includes the insulating layer 52 as a part of the interlayer insulating film 51. The insulating layer 52 is provided in a gap between the semiconductor substrate 21 and a semiconductor substrate 31 described below. The semiconductor substrate 21 is formed with a silicon substrate.

The second substrate 20 includes one readout circuit 22 for every four sensor pixels 12 (refer to FIGS. 2 and 3). The readout circuit 22 is provided in a portion on the back surface side (first substrate 10 side) of the semiconductor substrate 21. The second substrate 20 is bonded to the first substrate 10 with the back surface of the semiconductor substrate 21 facing the front surface side of the semiconductor substrate 11. That is, the second substrate 20 is bonded to the first substrate 10 in a face-to-back bonding.

The second substrate 20 further includes an insulating layer 53 penetrating the semiconductor substrate 21 in the same layer as the semiconductor substrate 21. The second substrate 20 includes the insulating layer 53 as a part of the interlayer insulating film 51. The insulating layer 53 is provided so as to cover a side surface of a through-substrate wiring line 54 described below.

A stacked body formed by the first substrate 10 and the second substrate 20 includes an interlayer insulating film 51 and a through-substrate wiring line 54 provided in the interlayer insulating film 51. The stacked body has one through-substrate wiring line 54 for every four sensor pixels 12. The through-substrate wiring line 54 extends in the normal direction of the semiconductor substrate 21 so as to penetrate a portion including the insulating layer 53 in the interlayer insulating film 51. The first substrate 10 and the second substrate 20 are electrically connected to each other by the through-substrate wiring line 54. The through-substrate wiring line 54 is, for example, a through-substrate contact for the floating diffusion FD (FD1 to FD4) depicted in FIG. 4.

The stacked body including the first substrate 10 and the second substrate 20 also includes another through-substrate wiring line (not depicted) provided in the interlayer insulating film 51. Similarly to the through-substrate wiring line 54, the through-substrate wiring line described above also extends in the normal direction of the semiconductor substrate 21, and is provided so as to penetrate a portion including an insulating layer having the same configuration as the insulating layer 53 in the interlayer insulating film 51. The first substrate 10 and the second substrate 20 are electrically connected to each other by the through-substrate wiring line. The through-substrate wiring line is, for example, a through-substrate contact for the transfer gate TG (TG1 to TG4) depicted in FIG. 4, a through-substrate contact for the well tap WT depicted in FIG. 4, or the like.

The second substrate 20 includes, for example, a plurality of connection portions 59 electrically connected to the readout circuit 22 and the semiconductor substrate 21 in the insulating layer 52. Furthermore, the second substrate 20 includes a wiring layer 56 on the insulating layer 52, for example. The wiring layer 56 includes: an insulating layer 57; and a plurality of pixel drive lines 23 and a plurality of vertical signal lines 24 provided in the insulating layer 57, for example. The wiring layer 56 further includes, for example, a connection wiring line 55 in the insulating layer 57 for each floating diffusion FD. The connection wiring line 55 is electrically connected to the through-substrate wiring line 54 connected to the floating diffusion FD.

Here, the total number of the through-substrate wiring lines 54 functioning as the through-substrate contact for the floating diffusion FD is smaller than the total number of the sensor pixels 12 included in the first substrate 10. For example, since the number of the sensor pixels 12 sharing the floating diffusion FD is 4, the total number of the through-substrate wiring lines 54 is one-fourth of the total number of the sensor pixels 12 included in the first substrate 10. Similarly, the total number of through-substrate wiring lines (not depicted) functioning as the through-substrate contact for the transfer gate TG, as well as the total number of through-substrate wiring lines (not depicted) functioning as the through-substrate contact for the well tap WT, is 1/4 times the total number of the sensor pixels 12 included in the first substrate 10, for example.

The wiring layer 56 further includes a plurality of pad electrodes 58 in the insulating layer 57, for example. Each pad electrode 58 is formed of metal such as copper (Cu) or aluminum (Al), for example. Each pad electrode 58 is exposed on the surface of the wiring layer 56. Each pad electrode 58 is used for electrical connection between the second substrate 20 and the third substrate 30 and bonding between the second substrate 20 and the third substrate 30. For example, one pad electrode 58 is provided for each of the pixel drive lines 23 and the vertical signal lines 24.

The third substrate 30 has a configuration in which an interlayer insulating film 61 is stacked on a semiconductor substrate 31, for example. The semiconductor substrate 31 is formed with a silicon substrate. As will be described below, since the third substrate 30 is bonded to the second substrate 20 on the front surface side, the vertical description is opposite to the vertical direction in the drawings in the description of the configuration in the third substrate 30.

The third substrate 30 has a configuration in which the logic circuit 32 is provided in a portion on the front surface side of the semiconductor substrate 31. The third substrate 30 includes a wiring layer 62 on the interlayer insulating film 61, for example. The wiring layer 62 includes: an insulating layer 63; and a plurality of pad electrodes 64 provided in the insulating layer 63, for example. Each pad electrode 64 is electrically connected to the logic circuit 32. Each pad electrode 64 is formed of copper (Cu), for example. Each pad electrode 64 is exposed on the surface of the wiring layer 62. Each pad electrode 64 is used for electrical connection between the second substrate 20 and the third substrate 30 and bonding between the second substrate 20 and the third substrate 30. The number of pad electrodes 64 need not be provided in plurality.

With the pad electrodes 58 and 64 bonded to each other, the third substrate 30 and the second substrate 20 are electrically connected to each other. The third substrate 30 is bonded to the second substrate 20 with the front surface of the semiconductor substrate 31 facing the front surface side of the semiconductor substrate 21. That is, the third substrate 30 is bonded to the second substrate 20 in a face-to-face bonding.

### <1-6. Modification of pixel circuit>

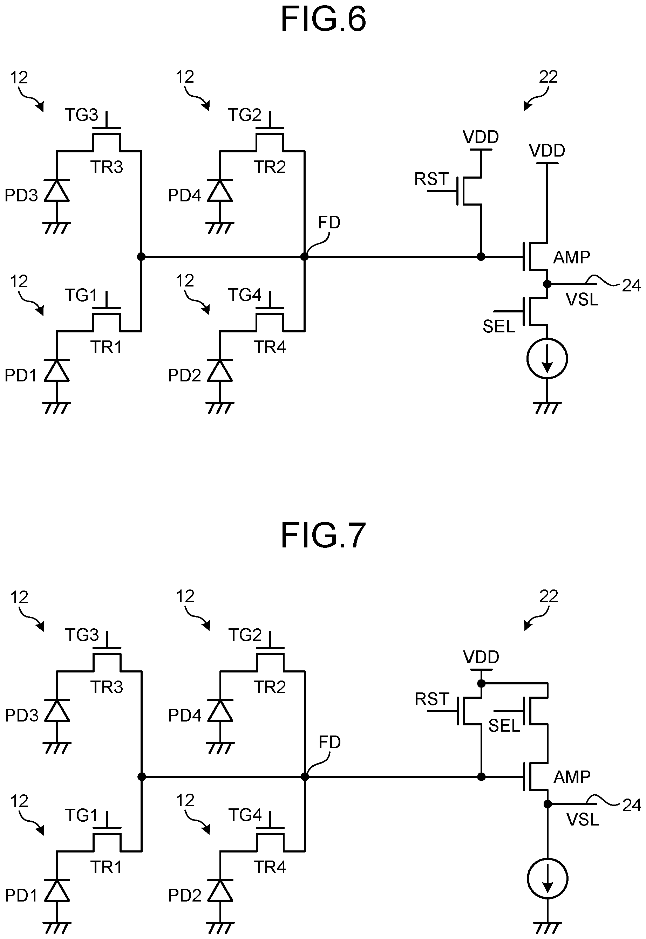

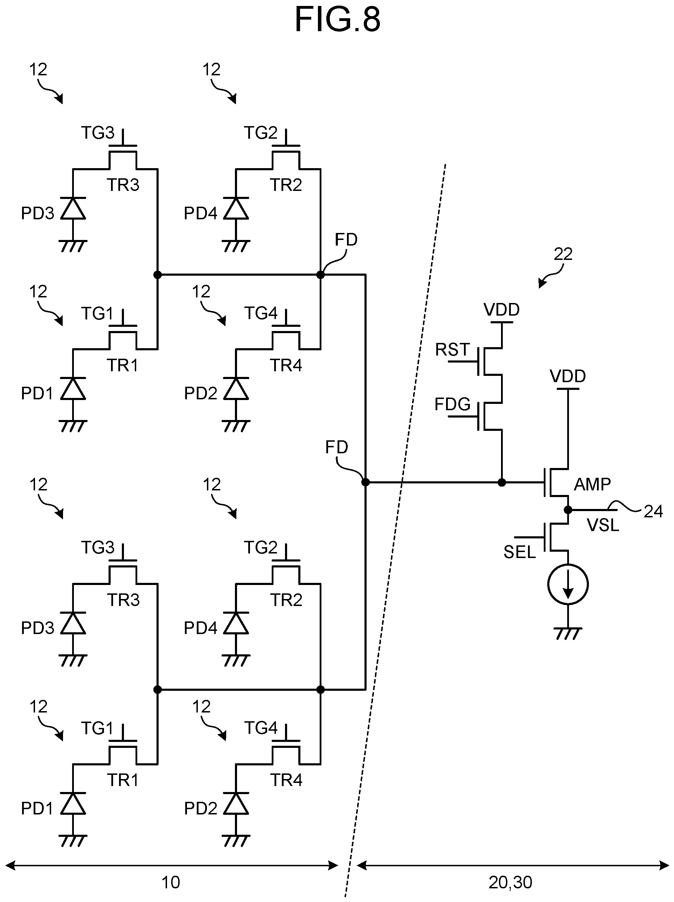

Modifications of the pixel circuit according to the first embodiment will be described with reference to FIGS. 6 to 8. FIG. 6 is a diagram depicting a first modification of the pixel circuit according to the first embodiment. FIG. 7 is a diagram depicting a second modification of the pixel circuit according to the first embodiment. FIG. 8 is a diagram depicting a third modification of the pixel circuit according to the first embodiment.

As depicted in FIG. 6, the FD transfer transistor FDG may be omitted. As depicted in FIG. 7, the FD transfer transistor FDG may be omitted, and the selection transistor SEL may be provided between the power supply line VDD and the amplification transistor AMP. In this case, the drain of the reset transistor RST is electrically connected to the power supply line VDD and the drain of the selection transistor SEL. The source of the selection transistor SEL is electrically connected to the drain of the amplification transistor AMP, while the gate of the selection transistor SEL is electrically connected to the pixel drive line 23 (refer to FIG. 1). The source of the amplification transistor AMP (an output end of the readout circuit 22) is electrically connected to the vertical signal line 24, while the gate of the amplification transistor AMP is electrically connected to the source of the reset transistor RST. As depicted in FIG. 8, eight sensor pixels 12 may share one floating diffusion FD.

Note that the pixel circuit is not limited to the pixel circuits depicted in FIGS. 2 and 6 to 8. For example, an element (for example, a gate for resetting the photodiode PD) may be added to the first substrate 10, or the configuration of the readout circuit 22 of the second substrate 20 may be modified.

### <1-7. Modification of cross-sectional configuration of imaging element>

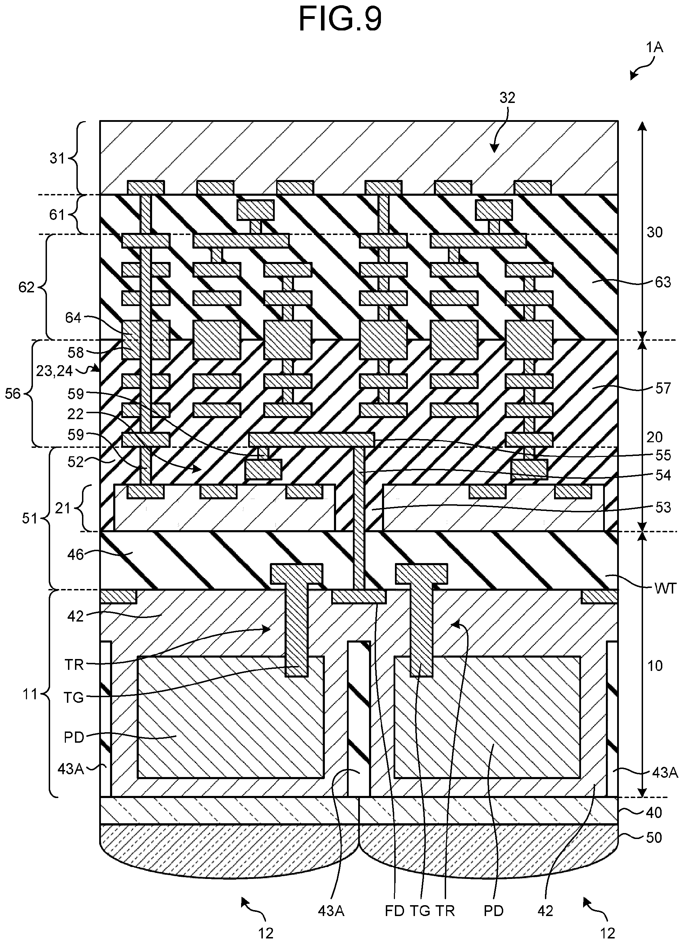

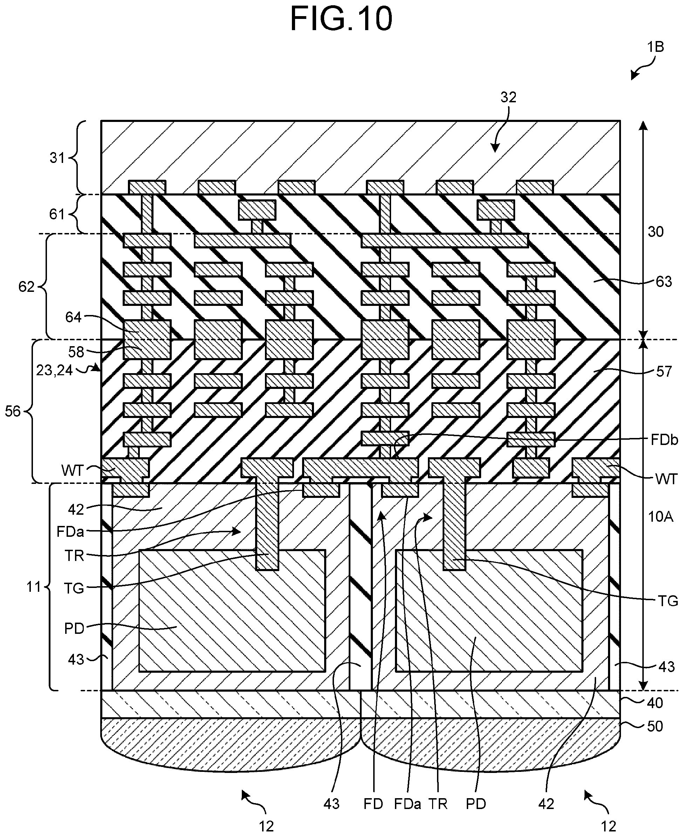

A modification of the cross-sectional configuration of an imaging element 1A according to the first embodiment will be described with reference to FIGS. 9 and 10. FIG. 9 is a diagram depicting a first modification of the longitudinal cross-sectional configuration of the imaging element 1A according to the first embodiment. FIG. 10 is a diagram depicting a second modification of the longitudinal cross-sectional configuration of the imaging element 1A according to the first embodiment.

As depicted in FIG. 9, the imaging element 1A includes an element isolating portion 43A. The element isolating portion 43A is a deep trench isolation (DTI) type isolating portion in which a trench is formed from the back surface to the middle of the semiconductor substrate 11. The floating diffusion FD is formed in the p-well layer 42, and is one diffusion layer (floating diffusion layer) commonly used by the four adjacent sensor pixels 12.

As depicted in FIG. 10, an imaging element 1B has a two-layer structure including a first substrate 10A and a third substrate 30. The first substrate 10A includes a wiring layer 56 having a through-substrate wiring line. The first substrate 10A and the third substrate 30 are bonded to each other by Cu-Cu bonding. Cu-Cu bonding is a bonding method in which not only two substrates are physically bonded, but also electrical conduction is ensured by exposing Cu pads at bonding interfaces on the substrates and bonding both pads. Note that, in the imaging element 1B, a part of a circuit such as an analog circuit or a logic circuit other than the sensor pixel 12 is disposed around (for example, the periphery of the pixel array on the first substrate 10) the pixel array which is the pixel region 13 (refer to FIG. 1).

### <1-8. Modification of planar layout of first layer>

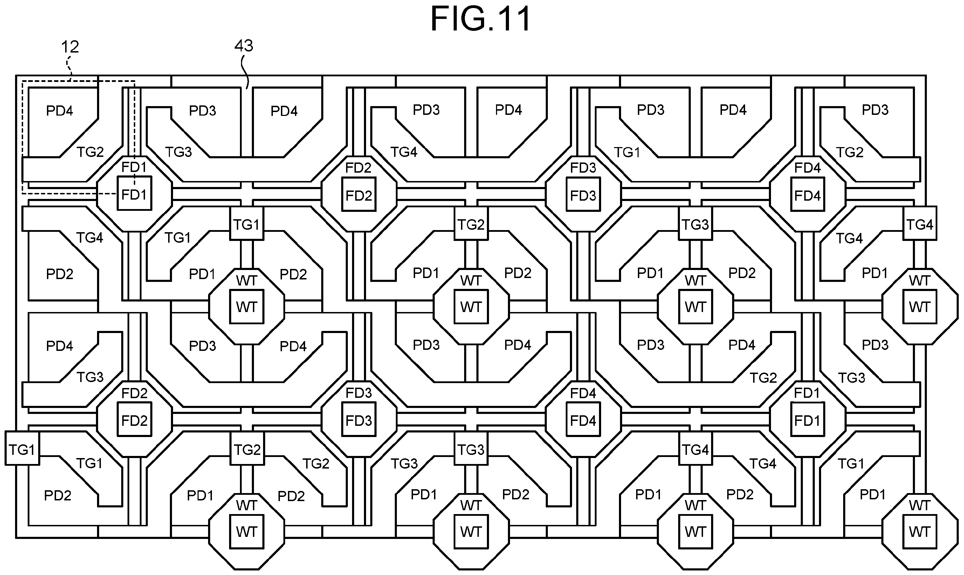

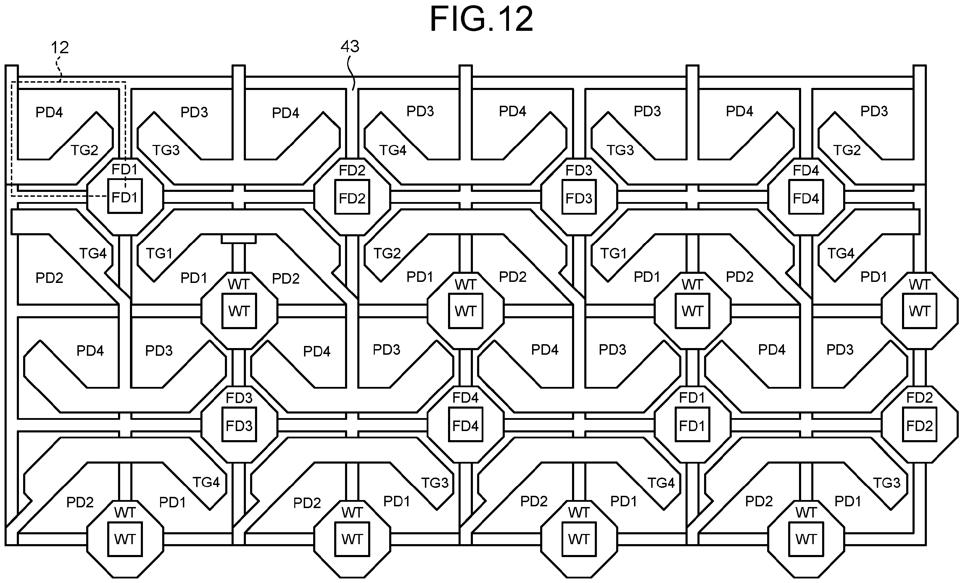

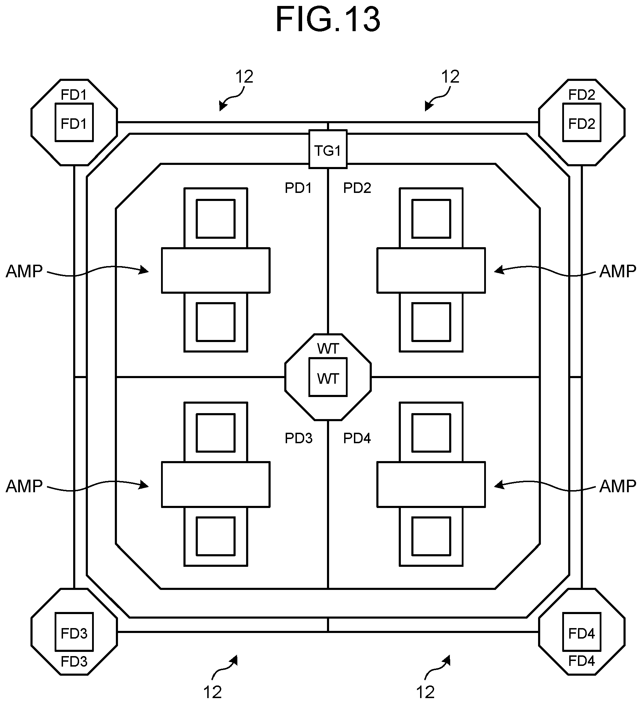

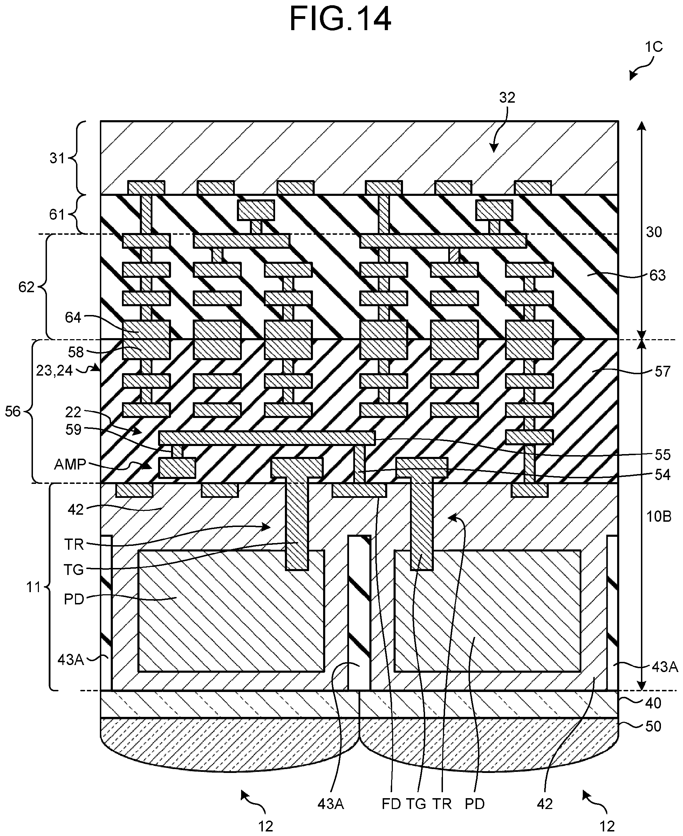

A modification of the planar layout of the first layer according to the first embodiment will be described with reference to FIGS. 11 to 14. FIG. 11 is a diagram depicting a first modification of the planar layout of the first layer according to the first embodiment. FIG. 12 is a diagram depicting a second modification of the planar layout of the first layer according to the first embodiment. FIG. 13 is a diagram depicting a third modification of the planar layout of the first layer according to the first embodiment. FIG. 14 is a diagram depicting an example of a longitudinal cross-sectional configuration of an imaging element 1C according to the third modification of FIG. 13. In the third modification, differences from the imaging element 1A (refer to FIG. 9) will be described.

As depicted in FIGS. 11 and 12, the transfer gates TG are integrated and electrically connected in four photodiodes PD not sharing the floating diffusion FD. As long as the transfer gates TG are integrated in the four photodiodes PD not sharing the floating diffusion FD, the shapes of the transfer gates TG is not limited. As the shape of the integrated transfer gates TG (TG1 to TG4), a shape as in the example of FIG. 11 or 12 can be adopted.

In the example of FIG. 11, the integrated transfer gate TG (TG1 to TG4) has an S-shape or an inverted S-shape (a shape in which the S-shape is vertically inverted). The integrated transfer gate TG is formed over a region (first region) surrounded by the four floating diffusions FD and a region (second region) located adjacent to the region and surrounded by the four floating diffusions FD.

In the example of FIG. 12, the floating diffusion FD is shifted by one column of the sensor pixels 12 every two rows of the sensor pixels 12. The well tap WT is shifted in a direction opposite to the shift direction of the floating diffusion FD by one column of the sensor pixels 12 every two rows of the sensor pixels 12. For example, the floating diffusion FD is shifted rightward, and the well tap WT is shifted leftward. According to this arrangement, the shape of the integrated transfer gate TG is modified.

As depicted in FIGS. 13 and 14, the amplification transistor AMP is provided on the front surface side of the semiconductor substrate 11 (refer to FIG. 14) for each sensor pixel 12 (photodiode PD). As depicted in FIG. 14, the imaging element 1C has a two-layer structure including a first substrate 10B and a third substrate 30. The first substrate 10B includes: a readout circuit 22 having an amplification transistor AMP and the like: a wiring layer 56 having a through-substrate wiring line, and the like. Although the pixel portion of the imaging element 1C has a single-layer structure, the number of through-substrate contacts can still be reduced even with the pixel portion of a single layer.

### <1-9. Action and effect>

As described above, according to the first embodiment, the four photodiodes (examples of photoelectric conversion elements) PD sharing the floating diffusion (an example of the floating diffusion layer) FD are arranged in a matrix together with the floating diffusion FD, while the transfer gate TG of each of the four photodiodes PD not sharing the floating diffusion FD is integrated with each other. This makes it possible to dispose the transfer gate TG in one layer and connect one through-substrate contact (through-substrate wiring line) to the transfer gate TG. Accordingly, the number of through-substrate contacts can be reduced as compared with a case where through-substrate contacts are provided for each transfer gate TG. Furthermore, the transfer gate TG only needs to be disposed in one layer, making it possible to reduce the number of manufacturing steps as compared with a case where two or more layers are used to extend the material (for example, polysilicon) forming the transfer gate TG to the outer periphery of the pixel array. Furthermore, the through-substrate contact needs to be formed only in one layer instead of a plurality of layers, making it possible to suppress the depth of the through-substrate contact, leading to suppression of a decrease in yield. In this manner, productivity can be improved while reducing the number of through-substrate contacts.

In addition, the reduced number of through-substrate contacts makes it possible to achieve an increase in effective area and miniaturization of the second layer, having a further effect of reducing through-substrate contact parasitic capacitance. Specifically, it is necessary to make the transfer gate TG independent between the sensor pixels 12 sharing the same floating diffusion FD. However, when a material (for example, polysilicon) forming the transfer gate TG is extended to the outer periphery of the pixel array, the material needs to be used in two or more layers. This would increase the distance between the first and second silicon layers, which needs a deeper through-substrate contact, leading to occurrence of problems such as an increase in parasitic capacitance and a decrease in yield. In addition, since polysilicon has higher resistance than metal wiring material such as Cu or Al, there is a concern of occurrence of a difference in pulse shape between the outer periphery and the center of the pixel array at the time of pulse driving, leading to occurrence of inter-pixel characteristic deviation. These problems can be solved by the imaging elements 1 and 1A to 1C according to the first embodiment.

In addition, the integrated transfer gate TG is disposed to run over the element isolating portion 43. This facilitates sharing of the transfer gate TG among the plurality of sensor pixels 12 in one layer.

The floating diffusion FD includes: the diffusion layer (floating diffusion layer) FDa provided for each of the four photodiodes PD sharing the floating diffusion FD; and the connection layer FDb connecting the diffusion layers FDa to each other. With this configuration, even when the element isolating portion 43 has a full trench structure (structure in which the element isolating portion 43 penetrates the semiconductor substrate 11), the four photodiodes PD can share one floating diffusion FD.

In addition, the connection layer FDb is formed of the same material (for example, polysilicon) as the transfer gate TG. This enables the connection layer FDb and the transfer gate TG to be formed in the same step, making it possible to reduce the number of manufacturing steps.

The number of photodiodes PD sharing the floating diffusion FD is not limited to four, and only needs to be four or more. Furthermore, the number of photodiodes PD not sharing the floating diffusion FD is not limited to four, and only needs to be two or more (details will be described in an embodiment described below).

### <2. Second embodiment>

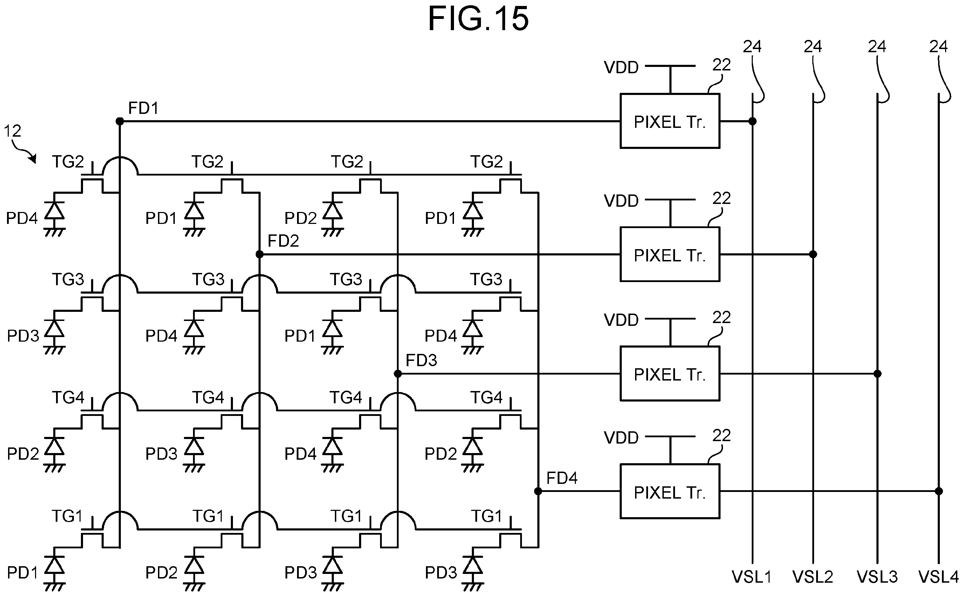

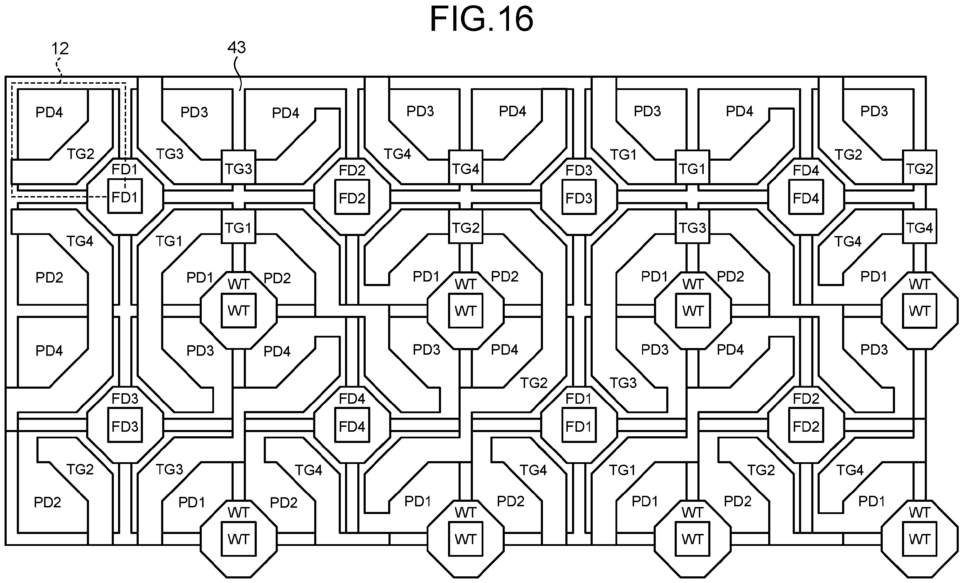

An example of a connection mode of the pixel circuit according to a second embodiment and an example of a planar layout of the first layer will be described with reference to FIGS. 15 and 16. FIG. 15 is a diagram depicting an example of a connection mode of the pixel circuit according to the second embodiment. FIG. 16 is a diagram depicting an example of a planar layout of a first layer according to the second embodiment;

As depicted in FIG. 15, the transfer gates TG1 in each of the PD1 of the FD1, the PD2 of the FD2, the PD3 of the FD3, and the PD3 of the FD4 are electrically connected to each other. The transfer gates TG4 in each of the PD2 of the FD1, the PD3 of the FD2, the PD4 of the FD3, and the PD2 of the FD4 are electrically connected to each other. The transfer gates TG3 in each of the PD3 of the FD1, the PD4 of the FD2, the PD1 of the FD3, and the PD4 of the FD4 are electrically connected to each other. The transfer gates TG2 in each of the PD4 of the FD1, the PD1 of the FD2, the PD2 of the FD3, and the PD1 of the FD4 are electrically connected to each other.

As depicted in FIG. 16, the transfer gates TG are integrated and electrically connected in four photodiodes PD not sharing the floating diffusion FD. As the shape of the integrated transfer gates TG (TG1 to TG4), a shape as in the example of FIG. 16 can be adopted. The integrated transfer gate TG is formed over a region (first region) surrounded by the four floating diffusions FD and a region (second region) located adjacent to the region and surrounded by the four floating diffusions FD.

As described above, according to the second embodiment, it is possible to adopt the shape as in the example of FIG. 16 as the shape of the integrated transfer gate TG. This makes it possible to increase the variation of the planar layout of the first layer and improve the degree of freedom in design. The second embodiment can achieve effect similar to those of the first embodiment.

### <3. Third embodiment>

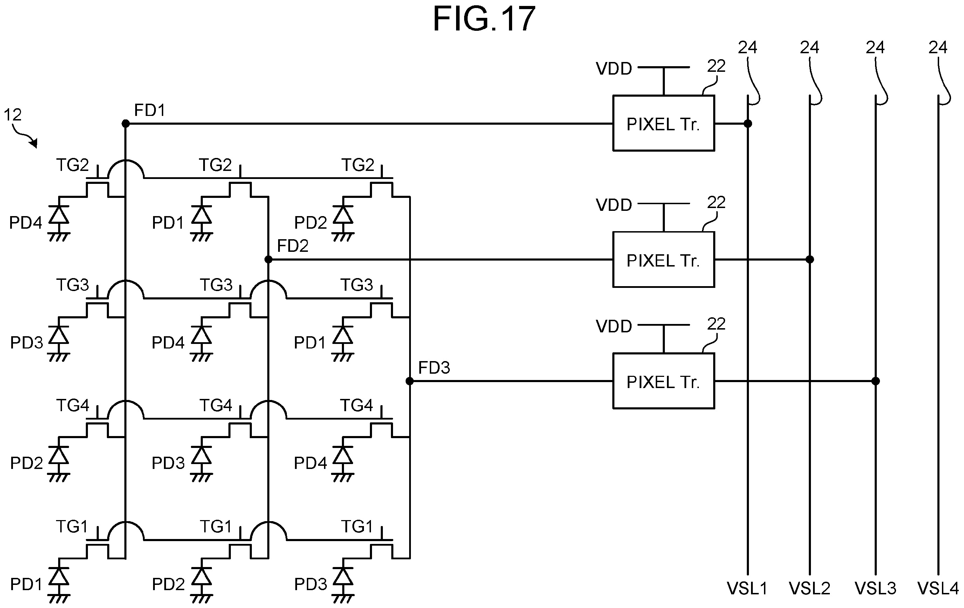

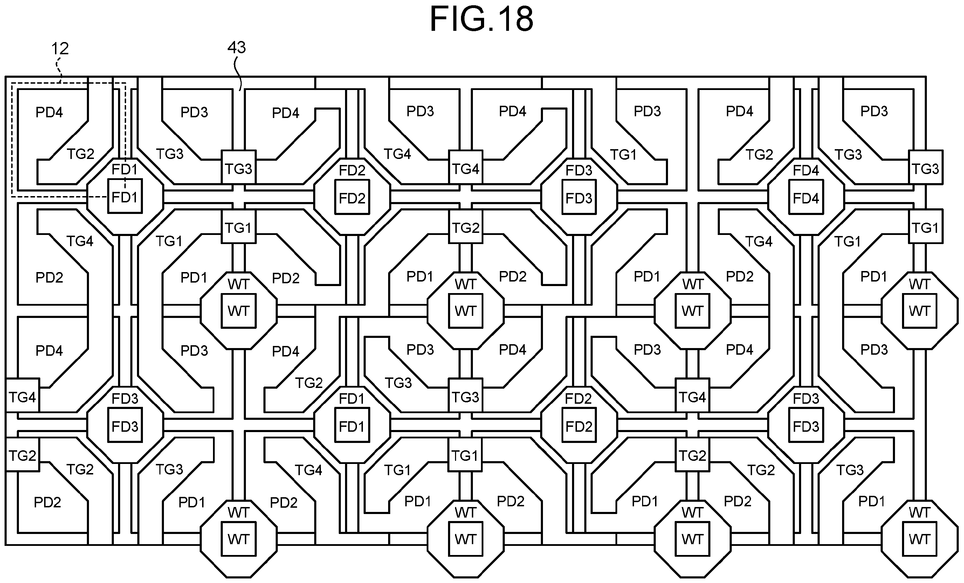

An example of a connection mode of the pixel circuit according to a third embodiment and an example of a planar layout of the first layer will be described with reference to FIGS. 17 and 18. FIG. 17 is a diagram depicting an example of a connection mode of the pixel circuit according to the third embodiment. FIG. 18 is a diagram depicting an example of a planar layout of a first layer according to the third embodiment.

As depicted in FIG. 17, the three transfer gates TG are electrically connected to each other. In the example of FIG. 17, the transfer gates TG1 in each of the PD1 of the FD1, the PD2 of the FD2, and the PD3 of the FD3 are electrically connected to each other. The transfer gates TG4 in each of the PD2 of the FD1, the PD3 of the FD2, and the PD4 of the FD3 are electrically connected to each other. The transfer gates TG3 in each of the PD3 of the FD1, the PD4 of the FD2, and the PD1 of the FD3 are electrically connected to each other. The transfer gates TG2 in each of the PD4 of the FD1, the PD1 of the FD2, and the PD2 of the FD3 are electrically connected to each other.

As depicted in FIG. 18, the transfer gates TG are integrated and electrically connected in three photodiodes PD not sharing the floating diffusion FD. As the shape of the integrated transfer gates TG (TG1 to TG4), two shapes (two different shapes) as in the example of FIG. 18 can be adopted. The integrated transfer gate TG is formed in a region (first region) surrounded by the four floating diffusions FD. In addition, the integrated transfer gate TG is formed over a region (first region) surrounded by the four floating diffusions FD and a region (second region) located adjacent to the region and surrounded by the four floating diffusions FD.

As described above, according to the third embodiment, it is possible to adopt the two shapes as in the example of FIG. 18 as the shape of the integrated transfer gate TG. This makes it possible to increase the variation of the planar layout of the first layer and improve the degree of freedom in design. The third embodiment can achieve effect similar to those of the first embodiment.

### <4. Fourth embodiment>

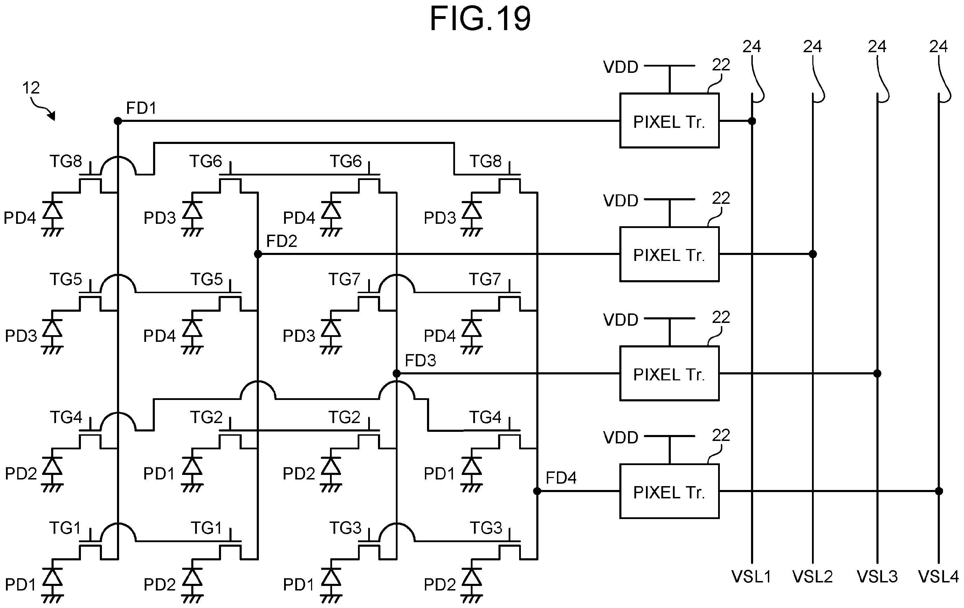

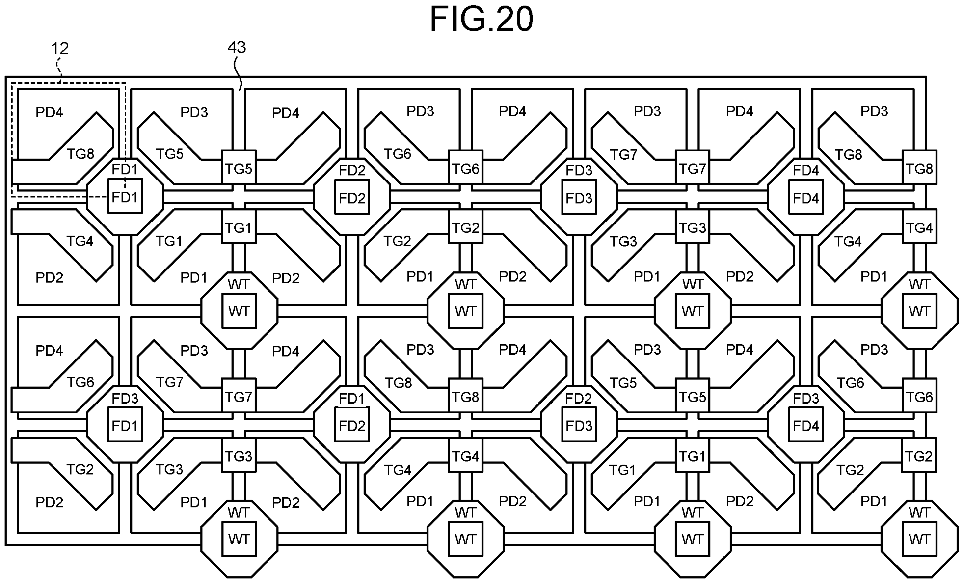

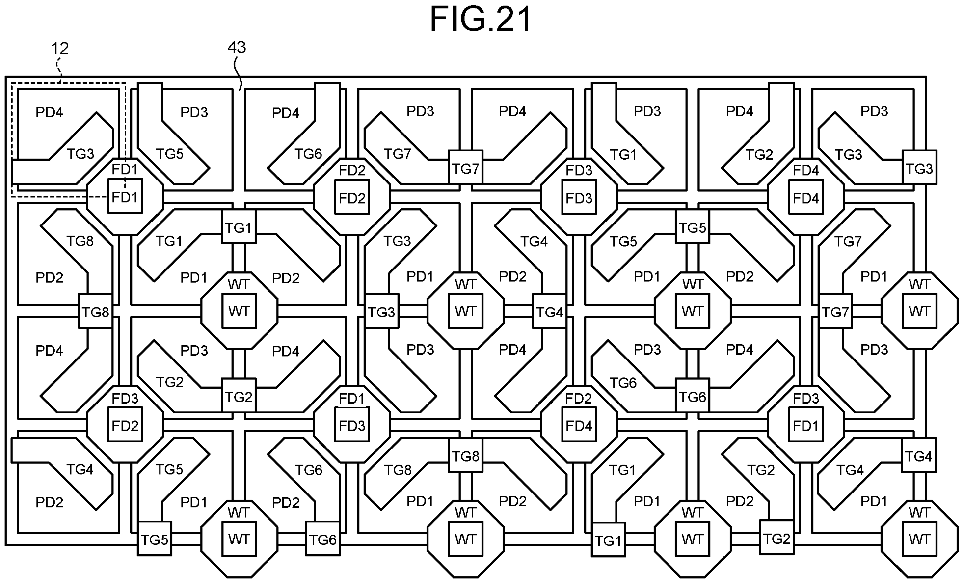

An example of a connection mode of the pixel circuit according to a fourth embodiment and an example of a planar layout of the first layer will be described with reference to FIGS. 19 to 21. FIG. 19 is a diagram depicting an example of a connection mode of the pixel circuit according to the fourth embodiment. FIG. 20 is a diagram depicting an example of a planar layout of a first layer according to the fourth embodiment; FIG. 21 is a diagram depicting a modification of the planar layout of the first layer according to the fourth embodiment.

As depicted in FIG. 19, the two transfer gates TG are electrically connected to each other. In the example of FIG. 19, the transfer gates TG1 in each of the PD1 of the FD1 and the PD2 of the FD2 are electrically connected to each other. The transfer gates TG4 in each of the PD2 of the FD1 and the PD1 of the FD4 are electrically connected to each other. The transfer gates TG5 in each of the PD3 of the FD1 and the PD4 of the FD2 are electrically connected to each other. The transfer gates TG8 in each of the PD4 of the FD1 and the PD3 of the FD4 are electrically connected to each other. The transfer gates TG2 in each of the PD1 of the FD2 and the PD2 of the FD3 are electrically connected to each other. The transfer gates TG6 in each of the PD3 of the FD2 and the PD4 of the FD3 are electrically connected to each other. The transfer gates TG3 in each of the PD1 of the FD3 and the PD2 of the FD4 are electrically connected to each other. The transfer gates TG7 in each of the PD3 of the FD3 and the PD4 of the FD4 are electrically connected to each other.

As depicted in FIG. 20, the transfer gates TG are integrated and electrically connected in two photodiodes PD not sharing the floating diffusion FD. As the shape of the integrated transfer gate TG, a shape as in the example of FIG. 20 can be adopted. The integrated transfer gate TG is formed in a region (first region) surrounded by the four floating diffusions FD.

As depicted in FIG. 21, a transfer gate TG having a shape as in the example of FIG. 20 is provided at a position rotated by 90 degrees. Similarly to FIG. 20, in the two photodiodes PD not sharing the floating diffusion FD, the transfer gates TG are integrated and electrically connected to each other. The integrated transfer gate TG is formed in a region (first region) surrounded by the four floating diffusions FD.

As described above, according to the fourth embodiment, it is possible to adopt the shape as in the example of FIG. 20 as the shape of the integrated transfer gate TG. This makes it possible to increase the variation of the planar layout of the first layer and improve the degree of freedom in design. The fourth embodiment can achieve effect similar to those of the first embodiment.

### <5. Other embodiments>

The process according to the embodiments described above may be performed in various different forms (modifications) in addition to the embodiments described above. For example, the configuration is not limited to the above-described example, and may have various modes. In addition, for example, the configurations, the processing procedures, specific names, and information including various data and parameters depicted in the above Literatures or drawings can be flexibly altered unless otherwise specified.

In addition, each of components of each device is provided as a functional and conceptional illustration and thus does not necessarily need to be physically configured as depicted. That is, the specific form of distribution/integration of each device is not limited to those depicted in the drawings, and all or a part thereof may be functionally or physically distributed or integrated into arbitrary units according to various loads and use conditions.

In the above embodiments and modifications, the conductivity types may be inversed. For example, in the description of each embodiment and each modification, the p-type may be replaced with the n-type, and the n-type may be replaced with the p-type. Even in this case, the effects similar to those of each embodiment and each modification can be obtained.

Furthermore, the imaging elements 1 and 1A to 1C according to the above-described embodiments and their modifications can be applied not only as visible light receiving elements but also to elements capable of detecting various types of radiation such as infrared rays, ultraviolet rays, X-rays, and electromagnetic waves. The imaging elements can also be applied to various applications such as distance measurement, light amount change detection, and physical property detection, in addition to image output.

### <6. Application examples>

The imaging elements 1, 1A to 1C according to the above embodiment and their modifications are applied to an imaging device. Examples of the imaging device include an electronic device such as a digital still camera, a video camera, a smartphone, a tablet terminal, a mobile phone, a personal digital assistant (PDA), or a laptop personal computer (PC).

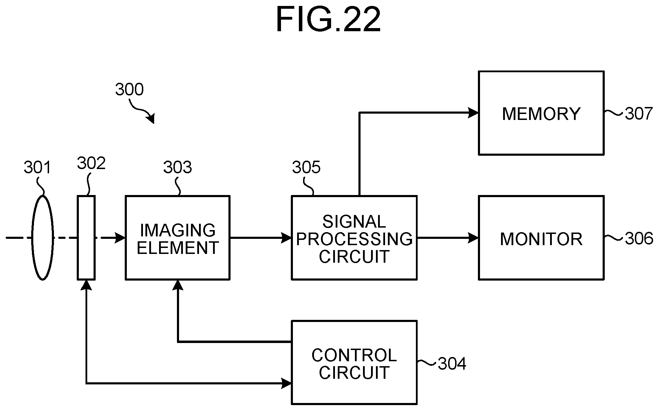

An example of an imaging device 300 will be described with reference to FIG. 22. FIG. 22 is a block diagram depicting an example of a schematic configuration of the imaging device 300 as an electronic device to which the present technology is applied.

As depicted in FIG. 22, the imaging device 300 includes an optical system 301, a shutter device 302, an imaging element 303, a control circuit (drive circuit) 304, a signal processing circuit 305, a monitor 306, and memory 307. The imaging device 300 can capture a still image and a moving image. The imaging element 303 is any one of the imaging elements 1, 1A to 1C according to the above-described embodiment and their modifications.

The optical system 301 includes one or a plurality of lenses. The optical system 301 guides light (incident light) from a subject to the imaging element 303 and forms an image on a light receiving surface of the imaging element 303.

The shutter device 302 is disposed between the optical system 301 and the imaging element 303. The shutter device 302 controls a light emission period and a light shielding period applied to the imaging element 303 under the control of the control circuit 304.

The imaging element 303 accumulates signal charges for a certain period in accordance with light formed on the light receiving surface via the optical system 301 and the shutter device 302. The signal charge accumulated in the imaging element 303 is transferred in accordance with a drive signal (timing signal) supplied from the control circuit 304.

The control circuit 304 outputs a drive signal for controlling the transfer operation of the imaging element 303 and the shutter operation of the shutter device 302 and thereby drives the imaging element 303 and the shutter device 302.

The signal processing circuit 305 performs various types of signal processing on the signal charge output from the imaging element 303. An image (image data) obtained by the signal processing performed by the signal processing circuit 305 is supplied to the monitor 306 and to the memory 307.

The monitor 306 displays a moving image or a still image captured by the imaging element 303 on the basis of the image data supplied from the signal processing circuit 305. Examples of the monitor 306 include a panel type display device such as a liquid crystal panel or an organic electro luminescence (EL) panel.

The memory 307 stores image data supplied from the signal processing circuit 305, that is, image data of a moving image or a still image captured by the imaging element 303. Examples of the memory 307 include a recording medium such as semiconductor memory or a hard disk.

By using any one of the imaging elements 1 and 1A to 1C described above as the imaging element 303 also in the imaging device 300 configured as described above, it is possible to reduce the number of through-substrate contacts and improve productivity.

### <7. Examples of application to products>

The technology according to the present disclosure is applicable to various products. For example, the technology according to the present disclosure may be applied to devices mounted on any of mobile body such as automobiles, electric vehicles, hybrid electric vehicles, motorcycles, bicycles, personal mobility, airplanes, drones, ships, robots, construction machines, agricultural machines (tractors). Moreover, for example, the technique according to the present disclosure may be applied to endoscope systems or microscopic surgery systems.

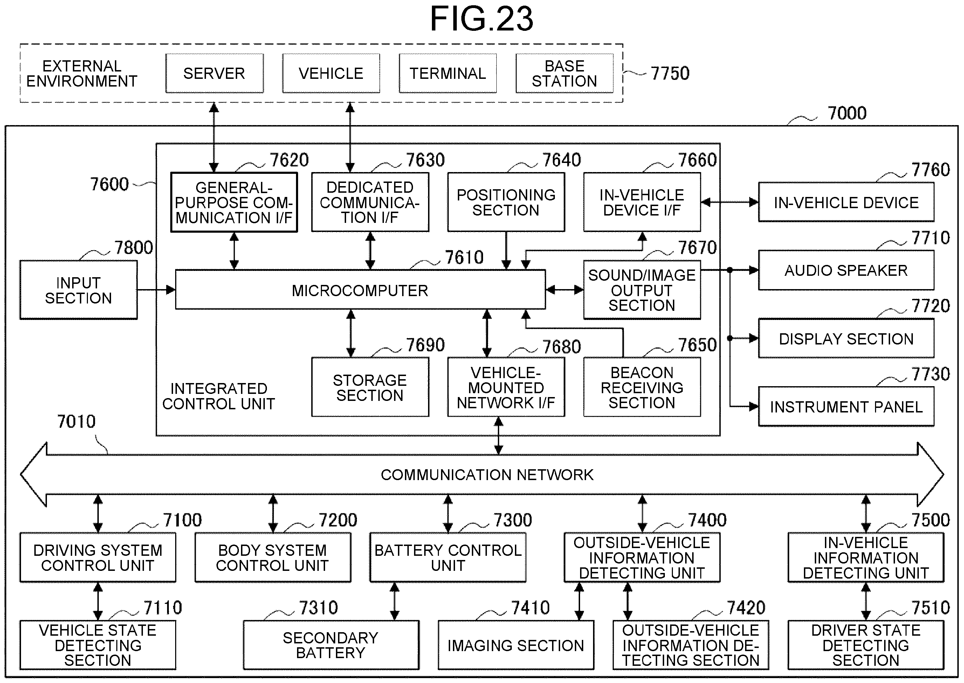

FIG. 23 is a block diagram depicting an example of schematic configuration of a vehicle control system 7000 as an example of a mobile body control system to which the technology according to an embodiment of the present disclosure can be applied. The vehicle control system 7000 includes a plurality of electronic control units connected to each other via a communication network 7010. In the example depicted in FIG. 23, the vehicle control system 7000 includes a driving system control unit 7100, a body system control unit 7200, a battery control unit 7300, an outside-vehicle information detecting unit 7400, an in-vehicle information detecting unit 7500, and an integrated control unit 7600. The communication network 7010 connecting the plurality of control units to each other may, for example, be a vehicle-mounted communication network compliant with an arbitrary standard such as controller area network (CAN), local interconnect network (LIN), local area network (LAN), FlexRay (registered trademark), or the like.

Each of the control units includes: a microcomputer that performs arithmetic processing according to various kinds of programs; a storage section that stores the programs executed by the microcomputer, parameters used for various kinds of operations, or the like; and a driving circuit that drives various kinds of control target devices. Each of the control units further includes: a network interface (I/F) for performing communication with other control units via the communication network 7010; and a communication I/F for performing communication with a device, a sensor, or the like within and without the vehicle by wire communication or radio communication. A functional configuration of the integrated control unit 7600 illustrated in FIG. 23 includes a microcomputer 7610, a general-purpose communication I/F 7620, a dedicated communication I/F 7630, a positioning section 7640, a beacon receiving section 7650, an in-vehicle device I/F 7660, a sound/image output section 7670, a vehicle-mounted network I/F 7680, and a storage section 7690. The other control units similarly include a microcomputer, a communication I/F, a storage section, and the like.

The driving system control unit 7100 controls the operation of devices related to the driving system of the vehicle in accordance with various kinds of programs. For example, the driving system control unit 7100 functions as a control device for a driving force generating device for generating the driving force of the vehicle, such as an internal combustion engine, a driving motor, or the like, a driving force transmitting mechanism for transmitting the driving force to wheels, a steering mechanism for adjusting the steering angle of the vehicle, a braking device for generating the braking force of the vehicle, and the like. The driving system control unit 7100 may have a function as a control device of an antilock brake system (ABS), electronic stability control (ESC), or the like.

The driving system control unit 7100 is connected with a vehicle state detecting section 7110. The vehicle state detecting section 7110, for example, includes at least one of a gyro sensor that detects the angular velocity of axial rotational movement of a vehicle body, an acceleration sensor that detects the acceleration of the vehicle, and sensors for detecting an amount of operation of an accelerator pedal, an amount of operation of a brake pedal, the steering angle of a steering wheel, an engine speed or the rotational speed of wheels, and the like. The driving system control unit 7100 performs arithmetic processing using a signal input from the vehicle state detecting section 7110, and controls the internal combustion engine, the driving motor, an electric power steering device, the brake device, and the like.

The body system control unit 7200 controls the operation of various kinds of devices provided to the vehicle body in accordance with various kinds of programs. For example, the body system control unit 7200 functions as a control device for a keyless entry system, a smart key system, a power window device, or various kinds of lamps such as a headlamp, a backup lamp, a brake lamp, a turn signal, a fog lamp, or the like. In this case, radio waves transmitted from a mobile device as an alternative to a key or signals of various kinds of switches can be input to the body system control unit 7200. The body system control unit 7200 receives these input radio waves or signals, and controls a door lock device, the power window device, the lamps, or the like of the vehicle.

The battery control unit 7300 controls a secondary battery 7310, which is a power supply source for the driving motor, in accordance with various kinds of programs. For example, the battery control unit 7300 is supplied with information about a battery temperature, a battery output voltage, an amount of charge remaining in the battery, or the like from a battery device including the secondary battery 7310. The battery control unit 7300 performs arithmetic processing using these signals, and performs control for regulating the temperature of the secondary battery 7310 or controls a cooling device provided to the battery device or the like.

The outside-vehicle information detecting unit 7400 detects information about the outside of the vehicle including the vehicle control system 7000. For example, the outside-vehicle information detecting unit 7400 is connected with at least one of an imaging section 7410 and an outside-vehicle information detecting section 7420. The imaging section 7410 includes at least one of a time-of-flight (ToF) camera, a stereo camera, a monocular camera, an infrared camera, and other cameras. The outside-vehicle information detecting section 7420, for example, includes at least one of an environmental sensor for detecting current atmospheric conditions or weather conditions and a peripheral information detecting sensor for detecting another vehicle, an obstacle, a pedestrian, or the like on the periphery of the vehicle including the vehicle control system 7000.

The environmental sensor, for example, may be at least one of a rain drop sensor detecting rain, a fog sensor detecting a fog, a sunshine sensor detecting a degree of sunshine, and a snow sensor detecting a snowfall. The peripheral information detecting sensor may be at least one of an ultrasonic sensor, a radar device, and a LIDAR device (Light detection and Ranging device, or Laser imaging detection and ranging device). Each of the imaging section 7410 and the outside-vehicle information detecting section 7420 may be provided as an independent sensor or device, or may be provided as a device in which a plurality of sensors or devices are integrated.

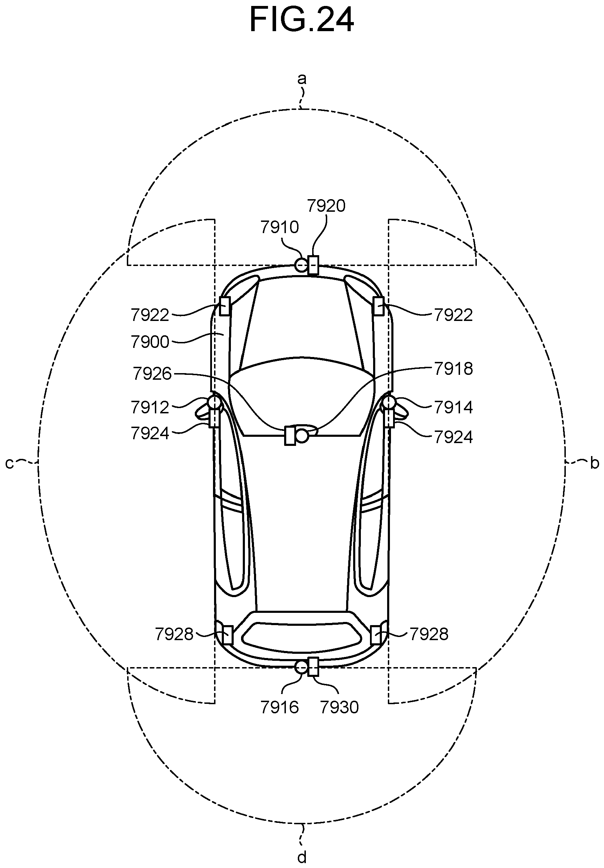

FIG. 24 depicts an example of installation positions of the imaging section 7410 and the outside-vehicle information detecting section 7420. Imaging sections 7910, 7912, 7914, 7916, and 7918 are, for example, disposed at at least one of positions on a front nose, sideview mirrors, a rear bumper, and a back door of the vehicle 7900 and a position on an upper portion of a windshield within the interior of the vehicle. The imaging section 7910 provided to the front nose and the imaging section 7918 provided to the upper portion of the windshield within the interior of the vehicle obtain mainly an image of the front of the vehicle 7900. The imaging sections 7912 and 7914 provided to the sideview mirrors obtain mainly an image of the sides of the vehicle 7900. The imaging section 7916 provided to the rear bumper or the back door obtains mainly an image of the rear of the vehicle 7900. The imaging section 7918 provided to the upper portion of the windshield within the interior of the vehicle is used mainly to detect a preceding vehicle, a pedestrian, an obstacle, a signal, a traffic sign, a lane, or the like.

Incidentally, FIG. 24 depicts an example of photographing ranges of the respective imaging sections 7910, 7912, 7914, and 7916. An imaging range a represents the imaging range of the imaging section 7910 provided to the front nose. Imaging ranges b and c respectively represent the imaging ranges of the imaging sections 7912 and 7914 provided to the sideview mirrors. An imaging range d represents the imaging range of the imaging section 7916 provided to the rear bumper or the back door. A bird's-eye image of the vehicle 7900 as viewed from above can be obtained by superimposing image data imaged by the imaging sections 7910, 7912, 7914, and 7916, for example.

Outside-vehicle information detecting sections 7920, 7922, 7924, 7926, 7928, and 7930 provided to the front, rear, sides, and corners of the vehicle 7900 and the upper portion of the windshield within the interior of the vehicle may be, for example, an ultrasonic sensor or a radar device. The outside-vehicle information detecting sections 7920, 7926, and 7930 provided to the front nose of the vehicle 7900, the rear bumper, the back door of the vehicle 7900, and the upper portion of the windshield within the interior of the vehicle may be a LIDAR device, for example. These outside-vehicle information detecting sections 7920 to 7930 are used mainly to detect a preceding vehicle, a pedestrian, an obstacle, or the like.

Returning to FIG. 23, the description will be continued. The outside-vehicle information detecting unit 7400 makes the imaging section 7410 image an image of the outside of the vehicle, and receives imaged image data. In addition, the outside-vehicle information detecting unit 7400 receives detection information from the outside-vehicle information detecting section 7420 connected to the outside-vehicle information detecting unit 7400. In a case where the outside-vehicle information detecting section 7420 is an ultrasonic sensor, a radar device, or a LIDAR device, the outside-vehicle information detecting unit 7400 transmits an ultrasonic wave, an electromagnetic wave, or the like, and receives information of a received reflected wave. On the basis of the received information, the outside-vehicle information detecting unit 7400 may perform processing of detecting an object such as a human, a vehicle, an obstacle, a sign, a character on a road surface, or the like, or processing of detecting a distance thereto. The outside-vehicle information detecting unit 7400 may perform environment recognition processing of recognizing a rainfall, a fog, road surface conditions, or the like on the basis of the received information. The outside-vehicle information detecting unit 7400 may calculate a distance to an object outside the vehicle on the basis of the received information.

In addition, on the basis of the received image data, the outside-vehicle information detecting unit 7400 may perform image recognition processing of recognizing a human, a vehicle, an obstacle, a sign, a character on a road surface, or the like, or processing of detecting a distance thereto. The outside-vehicle information detecting unit 7400 may subject the received image data to processing such as distortion correction, alignment, or the like, and combine the image data imaged by a plurality of different imaging sections 7410 to generate a bird's-eye image or a panoramic image. The outside-vehicle information detecting unit 7400 may perform viewpoint conversion processing using the image data imaged by the imaging section 7410 including the different imaging parts.

The in-vehicle information detecting unit 7500 detects information about the inside of the vehicle. The in-vehicle information detecting unit 7500 is, for example, connected with a driver state detecting section 7510 that detects the state of a driver. The driver state detecting section 7510 may include a camera that images the driver, a biosensor that detects biological information of the driver, a microphone that collects sound within the interior of the vehicle, or the like. The biosensor is, for example, disposed in a seat surface, the steering wheel, or the like, and detects biological information of an occupant sitting in a seat or the driver holding the steering wheel. On the basis of detection information input from the driver state detecting section 7510, the in-vehicle information detecting unit 7500 may calculate a degree of fatigue of the driver or a degree of concentration of the driver, or may determine whether the driver is dozing. The in-vehicle information detecting unit 7500 may subject an audio signal obtained by the collection of the sound to processing such as noise canceling processing or the like.

The integrated control unit 7600 controls general operation within the vehicle control system 7000 in accordance with various kinds of programs. The integrated control unit 7600 is connected with an input section 7800. The input section 7800 is implemented by a device capable of input operation by an occupant, such, for example, as a touch panel, a button, a microphone, a switch, a lever, or the like. The integrated control unit 7600 may be supplied with data obtained by voice recognition of voice input through the microphone. The input section 7800 may, for example, be a remote control device using infrared rays or other radio waves, or an external connecting device such as a mobile telephone, a personal digital assistant (PDA), or the like that supports operation of the vehicle control system 7000. The input section 7800 may be, for example, a camera. In that case, an occupant can input information by gesture. Alternatively, data may be input which is obtained by detecting the movement of a wearable device that an occupant wears. Further, the input section 7800 may, for example, include an input control circuit or the like that generates an input signal on the basis of information input by an occupant or the like using the above-described input section 7800, and which outputs the generated input signal to the integrated control unit 7600. An occupant or the like inputs various kinds of data or gives an instruction for processing operation to the vehicle control system 7000 by operating the input section 7800.

The storage section 7690 may include a read only memory (ROM) that stores various kinds of programs executed by the microcomputer and a random access memory (RAM) that stores various kinds of parameters, operation results, sensor values, or the like. In addition, the storage section 7690 may be implemented by a magnetic storage device such as a hard disc drive (HDD) or the like, a semiconductor storage device, an optical storage device, a magneto-optical storage device, or the like.

The general-purpose communication I/F 7620 is a communication I/F used widely, which communication I/F mediates communication with various apparatuses present in an external environment 7750. The general-purpose communication I/F 7620 may implement a cellular communication protocol such as global system for mobile communications (GSM (registered trademark)), worldwide interoperability for microwave access (WiMAX (registered trademark)), long term evolution (LTE (registered trademark)), LTE-advanced (LTE-A), or the like, or another wireless communication protocol such as wireless LAN (referred to also as wireless fidelity (Wi-Fi (registered trademark)), Bluetooth (registered trademark), or the like. The general-purpose communication I/F 7620 may, for example, connect to an apparatus (for example, an application server or a control server) present on an external network (for example, the Internet, a cloud network, or a company-specific network) via a base station or an access point. In addition, the general-purpose communication I/F 7620 may connect to a terminal present in the vicinity of the vehicle (which terminal is, for example, a terminal of the driver, a pedestrian, or a store, or a machine type communication (MTC) terminal) using a peer to peer (P2P) technology, for example.

The dedicated communication I/F 7630 is a communication I/F that supports a communication protocol developed for use in vehicles. The dedicated communication I/F 7630 may implement a standard protocol such, for example, as wireless access in vehicle environment (WAVE), which is a combination of institute of electrical and electronic engineers (IEEE) 802.11p as a lower layer and IEEE 1609 as a higher layer, dedicated short range communications (DSRC), or a cellular communication protocol. The dedicated communication I/F 7630 typically carries out V2X communication as a concept including one or more of communication between a vehicle and a vehicle (Vehicle to Vehicle), communication between a road and a vehicle (Vehicle to Infrastructure), communication between a vehicle and a home (Vehicle to Home), and communication between a pedestrian and a vehicle (Vehicle to Pedestrian).

The positioning section 7640, for example, performs positioning by receiving a global navigation satellite system (GNSS) signal from a GNSS satellite (for example, a GPS signal from a global positioning system (GPS) satellite), and generates positional information including the latitude, longitude, and altitude of the vehicle. Incidentally, the positioning section 7640 may identify a current position by exchanging signals with a wireless access point, or may obtain the positional information from a terminal such as a mobile telephone, a personal handyphone system (PHS), or a smart phone that has a positioning function.

The beacon receiving section 7650, for example, receives a radio wave or an electromagnetic wave transmitted from a radio station installed on a road or the like, and thereby obtains information about the current position, congestion, a closed road, a necessary time, or the like. Incidentally, the function of the beacon receiving section 7650 may be included in the dedicated communication I/F 7630 described above.

The in-vehicle device I/F 7660 is a communication interface that mediates connection between the microcomputer 7610 and various in-vehicle devices 7760 present within the vehicle. The in-vehicle device I/F 7660 may establish wireless connection using a wireless communication protocol such as wireless LAN, Bluetooth (registered trademark), near field communication (NFC), or wireless universal serial bus (WUSB). In addition, the in-vehicle device I/F 7660 may establish wired connection by universal serial bus (USB), high-definition multimedia interface (HDMI (registered trademark)), mobile high-definition link (MHL), or the like via a connection terminal (and a cable if necessary) not depicted in the figures. The in-vehicle devices 7760 may, for example, include at least one of a mobile device and a wearable device possessed by an occupant and an information device carried into or attached to the vehicle. The in-vehicle devices 7760 may also include a navigation device that searches for a path to an arbitrary destination. The in-vehicle device I/F 7660 exchanges control signals or data signals with these in-vehicle devices 7760.

The vehicle-mounted network I/F 7680 is an interface that mediates communication between the microcomputer 7610 and the communication network 7010. The vehicle-mounted network I/F 7680 transmits and receives signals or the like in conformity with a predetermined protocol supported by the communication network 7010.

The microcomputer 7610 of the integrated control unit 7600 controls the vehicle control system 7000 in accordance with various kinds of programs on the basis of information obtained via at least one of the general-purpose communication I/F 7620, the dedicated communication I/F 7630, the positioning section 7640, the beacon receiving section 7650, the in-vehicle device I/F 7660, and the vehicle-mounted network I/F 7680. For example, the microcomputer 7610 may calculate a control target value for the driving force generating device, the steering mechanism, or the braking device on the basis of the obtained information about the inside and outside of the vehicle, and output a control command to the driving system control unit 7100. For example, the microcomputer 7610 may perform cooperative control intended to implement functions of an advanced driver assistance system (ADAS) which functions include collision avoidance or shock mitigation for the vehicle, following driving based on a following distance, vehicle speed maintaining driving, a warning of collision of the vehicle, a warning of deviation of the vehicle from a lane, or the like. In addition, the microcomputer 7610 may perform cooperative control intended for automated driving, which makes the vehicle to travel automatedly without depending on the operation of the driver, or the like, by controlling the driving force generating device, the steering mechanism, the braking device, or the like on the basis of the obtained information about the surroundings of the vehicle.

The microcomputer 7610 may generate three-dimensional distance information between the vehicle and an object such as a surrounding structure, a person, or the like, and generate local map information including information about the surroundings of the current position of the vehicle, on the basis of information obtained via at least one of the general-purpose communication I/F 7620, the dedicated communication I/F 7630, the positioning section 7640, the beacon receiving section 7650, the in-vehicle device I/F 7660, and the vehicle-mounted network I/F 7680. In addition, the microcomputer 7610 may predict danger such as collision of the vehicle, approaching of a pedestrian or the like, an entry to a closed road, or the like on the basis of the obtained information, and generate a warning signal. The warning signal may, for example, be a signal for producing a warning sound or lighting a warning lamp.

The sound/image output section 7670 transmits an output signal of at least one of a sound and an image to an output device capable of visually or auditorily notifying information to an occupant of the vehicle or the outside of the vehicle. In the example of FIG. 23, an audio speaker 7710, a display section 7720, and an instrument panel 7730 are illustrated as the output device. The display section 7720 may, for example, include at least one of an on-board display and a head-up display. The display section 7720 may have an augmented reality (AR) display function. The output device may be other than these devices, and may be another device such as headphones, a wearable device such as an eyeglass type display worn by an occupant or the like, a projector, a lamp, or the like. In a case where the output device is a display device, the display device visually displays results obtained by various kinds of processing performed by the microcomputer 7610 or information received from another control unit in various forms such as text, an image, a table, a graph, or the like. In addition, in a case where the output device is an audio output device, the audio output device converts an audio signal constituted of reproduced audio data or sound data or the like into an analog signal, and auditorily outputs the analog signal.

Incidentally, at least two control units connected to each other via the communication network 7010 in the example depicted in FIG. 23 may be integrated into one control unit. Alternatively, each individual control unit may include a plurality of control units. Further, the vehicle control system 7000 may include another control unit not depicted in the figures. In addition, part or the whole of the functions performed by one of the control units in the above description may be assigned to another control unit. That is, predetermined arithmetic processing may be performed by any of the control units as long as information is transmitted and received via the communication network 7010. Similarly, a sensor or a device connected to one of the control units may be connected to another control unit, and a plurality of control units may mutually transmit and receive detection information via the communication network 7010.

Note that a computer program for implementing each function of the imaging device 300 according to the application example described with reference to FIG. 22 can be mounted on any control unit or the like. Furthermore, it is also possible to provide a computer-readable recording medium storing such a computer program. Examples of the recording medium include a magnetic disk, an optical disk, a magneto-optical disk, flash memory, or the like. Furthermore, the computer program described above may be distributed via a network, for example, without using a recording medium.

In the vehicle control system 7000 described above, the imaging device 300 according to the application example described with reference to FIG. 22 can be applied to the integrated control unit 7600 of the examples of application to products depicted in FIG. 23. For example, the control circuit 304, the signal processing circuit 305, and the memory 307 of the imaging device 300 may be implemented by the microcomputer 7610 or the storage section 7690 of the integrated control unit 7600. Furthermore, the imaging elements 1 and 1A to 1C according to each embodiment described with reference to FIG. 1 and the like can be applied to the imaging section 7410 and the outside-vehicle information detecting section 7420 of the application example depicted in FIG. 23, for example, the imaging sections 7910, 7912, 7914, 7916, and 7918 and the outside-vehicle information detecting section 7920 to 7930 of the examples of application to products depicted in FIG. 24. By using any one of the imaging elements 1 and 1A to 1C described above, it is possible to reduce the number of through-substrate contacts and improve productivity also in the vehicle control system 7000.

Furthermore, at least some components of the imaging device 300 according to the application example described with reference to FIG. 22 may be implemented in a module (for example, an integrated circuit module formed with one die) for the integrated control unit 7600 of the examples of application to products depicted in FIG. 23. Alternatively, a part of the imaging device 300 according to the application example described with reference to FIG. 22 may be implemented by a plurality of control units of the vehicle control system 7000 depicted in FIG. 23.

### <8. Supplementary notes>

Note that the present technique can also have the following configurations.
(1) An imaging element comprising:
   a floating diffusion layer that holds a charge;
   photoelectric conversion elements being four or more and sharing the floating diffusion layer; and
   a plurality of transfer gates that is provided for each of the photoelectric conversion elements being four or more and sharing the floating diffusion layer and that is configured to output the charge from the photoelectric conversion elements being four or more and sharing the floating diffusion layer,
   wherein the photoelectric conversion elements being four or more and sharing the floating diffusion layer are arranged in a matrix together with the floating diffusion layer, and
   the transfer gate of each of the photoelectric conversion elements being two or more and not sharing the floating diffusion layer is integrated with each other.
(2) The imaging element according to (1), further comprising
   a through-substrate wiring line connected to the transfer gate being integrated.
(3) The imaging element according to (1) or (2), further comprising
   an element isolating portion that is an insulating element and that electrically isolates at least partially between the photoelectric conversion elements being two or more and adjacent to each other,
   wherein the transfer gate being integrated is disposed to run over the element isolating portion.
(4) The imaging element according to (3),
   wherein the floating diffusion layer includes:
   a diffusion layer provided for each of the photoelectric conversion elements being four or more and sharing the floating diffusion layer; and
   a connection layer that connects each of the diffusion layers of the photoelectric conversion elements being four or more and sharing the floating diffusion layer.
(5) The imaging element according to (4),
   wherein the connection layer and the transfer gate are formed of a same material.
(6) The imaging element according to (5),
   wherein the material is polysilicon.
(7) The imaging element according to any one of (3) to (6),
   wherein the element isolating portion electrically completely isolates the photoelectric conversion elements being two or more and adjacent to each other, from each other.
(8) The imaging element according to any one of (1) to (7),
   wherein the transfer gate of each of the photoelectric conversion elements being four and not sharing the floating diffusion layer is integrated with each other.
(9) The imaging element according to (8),
   wherein the transfer gate being integrated is formed in a region surrounded by the floating diffusion layers being four.
(10) The imaging element according to (9),
   wherein the transfer gate being integrated has a ring shape.
(11) The imaging element according to (8),
   wherein the transfer gate being integrated is formed over a region surrounded by the floating diffusion layers being four and a region surrounded by the floating diffusion layers being four, located adjacent to the region.
(12) The imaging element according to (11),
   wherein the transfer gate being integrated has an S-shape or an inverted S-shape.
(13) The imaging element according to any one of (1) to (12), further comprising
   a well tap provided at a position diagonal to the floating diffusion layer for the photoelectric conversion element being one element.
(14) The imaging element according to any one of (1) to (13), further comprising
   a readout circuit that outputs an image signal based on the charge output from the floating diffusion layer,
   wherein the photoelectric conversion element, the floating diffusion layer, and the transfer gate are provided on a substrate being a first layer, and
   the readout circuit is provided on a second substrate being a second layer stacked on the substrate being the first layer.
(15) An imaging device comprising:
   an imaging element; and
   an optical system that forms a light image on a light receiving surface of the imaging element,
   wherein the imaging element includes:
      photoelectric conversion elements being four or more;
      a floating diffusion layer that holds charges output from the photoelectric conversion elements being four or more; and
      a plurality of transfer gates that is provided for each of the photoelectric conversion elements being four or more and that is configured to output the charge from the photoelectric conversion elements being four or more,
      the photoelectric conversion elements being four or more and sharing the floating diffusion layer are arranged in a matrix together with the floating diffusion layer, and
      the transfer gate of each of the photoelectric conversion elements being two or more and not sharing the floating diffusion layer is integrated with each other.
(16) An imaging device including the imaging element according to any one of (1) to (14) .

### Reference Signs List

- 1: IMAGING ELEMENT
- 1A: IMAGING ELEMENT
- 1B: IMAGING ELEMENT
- 1C: IMAGING ELEMENT
- 10: FIRST SUBSTRATE
- 10A: FIRST SUBSTRATE
- 10B: FIRST SUBSTRATE
- 11: SEMICONDUCTOR SUBSTRATE
- 12: SENSOR PIXEL
- 13: PIXEL REGION
- 20: SECOND SUBSTRATE
- 21: SEMICONDUCTOR SUBSTRATE
- 22: READOUT CIRCUIT
- 23: PIXEL DRIVE LINE
- 24: VERTICAL SIGNAL LINE
- 30: THIRD SUBSTRATE
- 31: SEMICONDUCTOR SUBSTRATE
- 32: LOGIC CIRCUIT
- 33: VERTICAL DRIVE CIRCUIT
- 34: COLUMN SIGNAL PROCESSING CIRCUIT
- 35: HORIZONTAL DRIVE CIRCUIT
- 36: SYSTEM CONTROL CIRCUIT
- 40: COLOR FILTER
- 42: p-WELL LAYER
- 43: ELEMENT ISOLATING PORTION
- 43A: ELEMENT ISOLATING PORTION
- 46: INSULATING LAYER
- 50: LIGHT RECEIVING LENS
- 51: INTERLAYER INSULATING FILM
- 52: INSULATING LAYER
- 53: INSULATING LAYER
- 54: THROUGH-SUBSTRATE WIRING LINE
- 55: CONNECTION WIRING LINE
- 56: WIRING LAYER
- 57: INSULATING LAYER
- 58: PAD ELECTRODE
- 59: CONNECTION PORTION
- 61: INTERLAYER INSULATING FILM
- 62: WIRING LAYER
- 63: INSULATING LAYER
- 64: PAD ELECTRODE
- 300: IMAGING DEVICE
- 301: OPTICAL SYSTEM
- 302: SHUTTER DEVICE
- 303: IMAGING ELEMENT
- 304: CONTROL CIRCUIT
- 305: SIGNAL PROCESSING CIRCUIT
- 306: MONITOR
- 307: MEMORY
- AMP: AMPLIFICATION TRANSISTOR
- FD: FLOATING DIFFUSION
- FDG: FD TRANSFER TRANSISTOR
- FDa: DIFFUSION LAYER
- FDb: CONNECTION LAYER
- PD: PHOTODIODE
- RST: RESET TRANSISTOR
- SEL: SELECTION TRANSISTOR
- TG: TRANSFER GATE
- TR: TRANSFER TRANSISTOR
- WT: WELL TAP

## Claims

1. An imaging element comprising:
a floating diffusion layer that holds a charge;
photoelectric conversion elements being four or more and sharing the floating diffusion layer; and
a plurality of transfer gates that is provided for each of the photoelectric conversion elements being four or more and sharing the floating diffusion layer and that is configured to output the charge from the photoelectric conversion elements being four or more and sharing the floating diffusion layer,
wherein the photoelectric conversion elements being four or more and sharing the floating diffusion layer are arranged in a matrix together with the floating diffusion layer, and
the transfer gate of each of the photoelectric conversion elements being two or more and not sharing the floating diffusion layer is integrated with each other.

2. The imaging element according to claim 1, further comprising
a through-substrate wiring line connected to the transfer gate being integrated.

3. The imaging element according to claim 1, further comprising
an element isolating portion that is an insulating element and that electrically isolates at least partially between the photoelectric conversion elements being two or more and adjacent to each other,
wherein the transfer gate being integrated is disposed to run over the element isolating portion.

4. The imaging element according to claim 3,
wherein the floating diffusion layer includes:
a diffusion layer provided for each of the photoelectric conversion elements being four or more and sharing the floating diffusion layer; and
a connection layer that connects each of the diffusion layers of the photoelectric conversion elements being four or more and sharing the floating diffusion layer.

5. The imaging element according to claim 4,
wherein the connection layer and the transfer gate are formed of a same material.

6. The imaging element according to claim 5,
wherein the material is polysilicon.

7. The imaging element according to claim 3,
wherein the element isolating portion electrically completely isolates the photoelectric conversion elements being two or more and adjacent to each other, from each other.

8. The imaging element according to claim 1,
wherein the transfer gate of each of the photoelectric conversion elements being four and not sharing the floating diffusion layer is integrated with each other.

9. The imaging element according to claim 8,
wherein the transfer gate being integrated is formed in a region surrounded by the floating diffusion layers being four.

10. The imaging element according to claim 9,
wherein the transfer gate being integrated has a ring shape.

11. The imaging element according to claim 8,
wherein the transfer gate being integrated is formed over a region surrounded by the floating diffusion layers being four and a region surrounded by the floating diffusion layers being four, located adjacent to the region.

12. The imaging element according to claim 11,
wherein the transfer gate being integrated has an S-shape or an inverted S-shape.

13. The imaging element according to claim 1, further comprising
a well tap provided at a position diagonal to the floating diffusion layer for the photoelectric conversion element being one element.

14. The imaging element according to claim 1, further comprising
a readout circuit that outputs an image signal based on the charge output from the floating diffusion layer,
wherein the photoelectric conversion element, the floating diffusion layer, and the transfer gate are provided on a substrate being a first layer, and
the readout circuit is provided on a second substrate being a second layer stacked on the substrate being the first layer.

15. An imaging device comprising:
an imaging element; and
an optical system that forms a light image on a light receiving surface of the imaging element,
wherein the imaging element includes:
photoelectric conversion elements being four or more;
a floating diffusion layer that holds charges output from the photoelectric conversion elements being four or more; and
a plurality of transfer gates that is provided for each of the photoelectric conversion elements being four or more and that is configured to output the charge from the photoelectric conversion elements being four or more,
the photoelectric conversion elements being four or more and sharing the floating diffusion layer are arranged in a matrix together with the floating diffusion layer, and
the transfer gate of each of the photoelectric conversion elements being two or more and not sharing the floating diffusion layer is integrated with each other.
An imaging element according to an aspect of the present disclosure includes: a floating diffusion layer (FD) that holds a charge; photoelectric conversion elements (PD) being four or more and sharing the floating diffusion layer (FD); and a plurality of transfer gates (TG) that is provided for each of the photoelectric conversion elements (PD) being four or more and sharing the floating diffusion layer (FD) and that is configured to output the charge from the photoelectric conversion elements (PD) being four or more and sharing the floating diffusion layer (FD), in which the photoelectric conversion elements (PD) being four or more and sharing the floating diffusion layer (FD) are arranged in a matrix together with the floating diffusion layer (FD), and the transfer gate (TG) of each of the photoelectric conversion elements (PD) being two or more and not sharing the floating diffusion layer (FD) is integrated with each other.
